# EUROPEAN PATENT APPLICATION

(11) **EP 2 581 943 A1**
(43) Date of publication of application: **17.04.2013**
(21) Application number: 11792571.9
(22) Date of filing: 10.06.2011
(51) Int. Cl.: H01L 31/04

(54) **TRANSLUCENT LAMINATE AND SOLAR CELL MODULE USING SAME**

(30) Priority: 11.06.2010 JP 2010134296
(71) Applicant: Asahi Glass Company, Limited, Tokyo 100-8405 (JP)
(72) Inventor: KAWAI, Yohei, Tokyo 100-8405 (JP); YONEDA, Takashige, Tokyo 100-8405 (JP)
(74) Representative: Ehlich, Hendrik
(86) International application number: PCT/JP2011/063416
(87) International publication number: WO 2011/155614

(57) **Abstract**

To provide a translucent substrate which sufficiently improves the power generation efficiency of a solar cell, and a solar cell module.

A translucent laminated film to be provided on the light receiving surface side of a photoelectric conversion layer, which comprises, in order from the light receiving surface side of the photoelectric conversion layer, a translucent substrate which protects the photoelectric conversion layer, a substrate front side wavelength conversion film having a wavelength conversion function to convert a light in a wavelength region in which the photoelectric conversion efficiency is low, which includes a light in a wavelength region in which the transmittance through at least the translucent substrate is low, into a light in a wavelength region in which the photoelectric conversion efficiency is high, and an antireflection film which reduces reflection of the received light.

## Description

### TECHNICAL FIELD

The present invention relates to a translucent laminated film and a solar cell module using it. More particularly, it relates to a translucent laminated film having at least antireflection function, wavelength conversion function and mechanical strength, and a solar cell module with a good photoelectric conversion efficiency using the laminated film as a protective cover.

### BACKGROUND ART

For solar cell modules, various attempts have been made in order to increase the photoelectric conversion efficiency.

For example, Patent Document 1 discloses a technique for a solar cell, to provide an antireflection film 1 on a side from which sunlight enters of a transparent protective cover 2, and a layer of a wavelength converter on a side from which the sunlight exits of the transparent protective cover 2 (see Fig. 1). Further, Patent Document 2 discloses a light receiving element comprising a wavelength conversion layer doped with a rare earth metal as dispersed from the surface to the bottom, which converts a part of short wavelength received light into longer wavelength light, prior to a photoelectric conversion layer, and having a layer not doped with a rare earth metal to prevent flying from the surface side when the rare earth metal is diffused, on the surface of the wavelength conversion layer (see claim 2).

Further, Patent Document 3 discloses a technique to disperse a fluorescent material or a luminescent material as a wavelength conversion material into a transparent substrate, to attach it to a transparent substrate, or to apply a coating having such a material dispersed in a transparent binder to a transparent substrate (see paragraph 0009). Further , Patent Document 4 discloses a technique to incorporate a fluorescent material as a wavelength conversion material into at least one of a transparent electrode layer, an electrode protecting layer and an antireflection layer of a solar cell (see claim 1). Further, Patent Document 5 discloses that a sealing material between a front cover and a single crystal cell constitutes a wavelength conversion layer (see paragraph 0027) and that a plurality of two sealing materials differing in the type of a conversion agent are provided on the single crystal cell (see paragraph 0053).

### PRIOR ART DOCUMENTS

### PATENT DOCUMENTS

Patent Document 1: JP-A-63-200576
Patent Document 2: JP-A-8-204222
Patent Document 3: JP-A-2001-185242
Patent Document 4: JP-A-2003-243682
Patent Document 5: JP-A-7-202243

### DISCLOSURE OF INVENTION

### TECHNICAL PROBLEM

In order that a solar cell module efficiently carries out the photoelectric conversion, an interaction among a translucent substrate, an antireflection film and a wavelength conversion film should be considered. However, with respect to conventional solar cell modules as disclosed in Patent Documents 1 to 5, the interaction has not necessarily been sufficiently studied.

Specifically, in Examples disclosed in Patent Document 1, a wavelength conversion layer is formed by vapor deposition using ZnS as a wavelength converter on a transparent protective cover glass. As ZnS has a relatively high refractive index of 2.4, if a relatively dense film is formed simply by vapor deposition, the reflectance on the glass surface, which was originally about 5%, is increased to about 20%. Accordingly, about 15% of light which reaches the photoelectric conversion layer is lost. Further, even by forming an antireflection layer on the glass surface, reflection can be prevented only about 5% at the maximum, and accordingly with such a layer constitution, about 10% of light is lost at the minimum. Accordingly, even with an effect capable of improving the power generation efficiency of a solar cell by about 10% by wavelength conversion, practically, no sufficient effect can be obtained due to the loss of light.

Further, Patent Document 2 discloses to provide the wavelength conversion layer directly on the photoelectric conversion layer, and failed to disclose to provide the wavelength conversion layer on a cover glass.

Further, Patent Document 3 discloses to attach or incorporate a wavelength conversion material to or into a cover glass, but failed to disclose the relation with an antireflection film. Further, Patent Document 4 discloses to incorporate a wavelength conversion material into an antireflection film on a silicone wafer, but failed to disclose to provide a wavelength conversion layer on a cover glass. Further, Patent Document 5 discloses to provide a wavelength conversion layer directly beneath a cover glass, but failed to disclose the relation with an antireflection film.

The present invention has been made to solve the above problems, and its object is to provide a translucent laminated film to be provided on the light receiving surface side of a photoelectric converting layer in an element having a photoelectric conversion layer such as a solar cell module, which makes a light in a wavelength region in which the photoelectric conversion efficiency is high efficiently reach the photoelectric conversion layer and which also has a protection function to increase the durability of the photoelectric conversion layer such as the weather resistance and the mechanical strength. Further, its object is to provide a solar cell module with a good photoelectric conversion efficiency using it.

### SOLUTION TO PROBLEM

According to a first embodiment of the present invention, provided is a translucent laminated film to be provided on the light receiving surface side of a photoelectric conversion layer, which comprises, in order from the light receiving surface side of the photoelectric conversion layer, a translucent substrate which protects the photoelectric conversion layer, a substrate front side wavelength conversion film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, and an antireflection film which reduces reflection of the received light.

According to a second embodiment of the present invention, provided is a translucent laminated film to be provided on the light receiving surface side of a photoelectric conversion layer, which comprises, in order from the light receiving surface side of the photoelectric conversion layer, a substrate rear side wavelength conversion film having a wavelength conversion function to convert a light in a wavelength region in which the photoelectric conversion efficiency by the photoelectric conversion layer is low, which has passed through the following translucent substrate, into a light in a wavelength region in which the photoelectric conversion efficiency is high, and having an average refractive index to a light having a wavelength of from 300 to 1,000 nm in the film thickness direction of from 1.2 to 2.0, a translucent substrate which protects the photoelectric conversion layer, and an antireflection film which prevents reflection of the received light.

According to a third embodiment of the present invention, provided is a translucent laminated film to be provided on the light receiving surface side of a photoelectric conversion layer, which comprises, in order from the light receiving surface side of the photoelectric conversion layer, a translucent substrate which protects the photoelectric conversion layer, and an optical functional film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, and having an antireflection function to reduce reflection of the received light.

The present invention further provides a protective cover on a light receiving surface side of a solar cell, which comprises the translucent laminated film according to any one of the above first to third embodiments of the present invention.

The present invention further provides a solar cell module, which comprises the translucent laminated film according to any one of the above first to third embodiments of the present invention, as a protective cover on the light receiving surface side of a solar cell.

In this specification, "from ··· to ···" indicating the range of numbers is meant to include the indicated values as the lower limit value and the upper limit value, unless otherwise specified, and the same applies hereinafter.

### ADVANTAGEOUS EFFECTS OF INVENTION

The translucent laminated film of the present invention, in an element having a photoelectric conversion layer such as a solar cell module, is capable of making a light in a wavelength region in which the photoelectric conversion efficiency is high, reach the photoelectric conversion layer when being provided on the light receiving side of the photoelectric conversion layer, and can also function as a protective layer to increase the durability of the photoelectric conversion layer such as the weather resistance and the mechanical strength. Further, according to the present invention, it is possible to provide a solar cell module with a good photoelectric conversion efficiency by using the translucent laminated film as a protective cover on the light receiving surface side of a solar cell.

### BRIEF DESCRIPTION OF DRAWINGS

Fig. 1 is a cross sectional view illustrating an example of a translucent laminated film according to a first embodiment of the present invention.
Fig. 2 is a cross sectional view illustrating an example of a translucent laminated film according to a second embodiment of the present invention.
Fig. 3 is a cross sectional view illustrating an example of a translucent laminated film according to a third embodiment of the present invention.

### DESCRIPTION OF EMBODIMENTS

Now, the present invention will be described in detail.

The translucent laminated film of the present invention is a translucent laminated film to be provided on the light receiving surface side of a photoelectric conversion layer, and specifically, the after-mentioned first to third embodiments may be mentioned. The translucent laminated film according to each embodiment has translucency and the respective functions of an antireflection function and a wavelength conversion function.

Among these functions, the translucency and the antireflection function are preferably as high as possible, in order that the received light is effectively subjected to photoelectric conversion to a light in a wavelength region in which the photoelectric conversion efficiency of the photoelectric conversion layer for which the translucent laminated film of the present invention is to be used is high, although they depend on the photoelectric conversion layer used.

The average transmittance of the translucent laminated film of the present invention to light is preferably from 90 to 100%, more preferably from 92 to 100%, further preferably from 93 to 100%, in a wavelength region in which the photoelectric conversion efficiency by the photoelectric conversion layer to be used is high (hereinafter such a region will sometimes be referred to as "effective wavelength region"), as the average of transmittances every 5 nm of light which is transmitted from the light receiving surface side of the translucent laminated film to the opposite side to the light receiving surface (hereinafter the surface on the side opposite to the light receiving surface will be referred to as "non-light receiving surface", and the side opposite to the light receiving surface will sometimes be referred to as "non-light receiving surface side") as measured based on JIS R3106.

The effective wavelength region specifically depends on the type of the photoelectric conversion layer to be used. For example, with respect to a solar cell, in a case where the solar cell is a crystalline silicon solar cell, it is from 400 to 1,100 nm, from 400 to 1,200 nm in the case of a CIGS compound type solar cell, from 400 to 1,200 nm in the case of a CdTe compound solar cell, and from 350 to 750 nm in the case of an amorphous silicon, organic or dye-sensitized solar cell.

Further, the average transmittance of the translucent laminated film to light measured in the same manner as above, is preferably from 0 to 30%, more preferably from 0 to 20%, further preferably from 0 to 10%, in a wavelength region in which the photoelectric conversion efficiency by the photoelectric conversion layer to be used is low (hereinafter such a wavelength region will sometimes be referred to as "ineffective wavelength region").

The ineffective wavelength region specifically depends on the type of the photoelectric conversion layer to be used. For example, with respect to a solar cell, in a case where the solar cell is a crystalline silicon solar cell, it is from 200 to 400 nm and from 1,100 to 4,000 nm, from 200 to 400 nm and from 1,200 to 4,000 nm in the case of a CIGS compound type solar cell, from 200 to 400 nm and from 1,200 to 4,000 nm in the case of a CdTe compound type solar cell, and from 200 to 350 nm and from 750 to 4,000 nm in the case of an amorphous silicon, organic or dye-sensitized solar cell.

Here, the effective wavelength region of each of the above-described solar cells is a wavelength region in which the quantum efficiency is at least 10% based on the quantum efficiency at the maximum peak wavelength being 100% when the quantum efficiency of the solar cell is measured by a solar simulator, and the ineffective wavelength region is a wavelength region in which it is less than 10%.

In this specification, the wavelength region in which the photoelectric conversion efficiency is low is a wavelength region substantially belonging to the ineffective wavelength region and the wavelength region in which the photoelectric conversion efficiency is high is a wavelength region substantially belonging to the effective wavelength region, and the photoelectric conversion efficiency is not divided by a certain threshold into regions in which the photoelectric conversion efficiency is low or high. They are used with reference to relative photoelectric conversion efficiencies of the light before conversion and the light after conversion.

By forming the wavelength conversion layer on the light receiving surface side of a photoelectric conversion layer, for example, a solar cell, it is possible to convert a light in the ineffective wavelength region which will not contribute to power generation of the solar cell into a light in the effective wavelength region which can be photoelectrically converted by a solar cell, thereby to improve the power generation efficiency of the solar cell. The ineffective/effective wavelength regions for a solar cell are determined by the band gap of the photoelectric conversion material and substances present on the light receiving surface side (such as constituent materials for the protective layer, the transparent electrically conductive layer, the buffer layer and the like). The sunlight is the broad spectrum at wavelengths of substantially from 200 to 4,000 nm, and the light in wavelength regions other than ones absorbed or scattered by the atmosphere reaches the earth.

On the other hand, crystalline silicon which is a representative photoelectric conversion material of a solar cell, of which the band gap is 1.1 eV, can absorb only light having a wavelength of at most 1,100 nm corresponding to the band gap, and transmits infrared light having a wavelength of at least 1,100 nm. Further, as ultraviolet light having a wavelength of at most 400 nm has a too short wavelength relative to the band gap (i.e. it has too high energy), it will not be photoelectrically converted and lost as a heat energy. Accordingly, it is possible to improve the power generation efficiency by converting an ineffective long wavelength light of at least 1,100 nm into an effective wavelength light of from 400 to 1,100 nm (hereinafter this conversion will sometimes be referred to as up conversion) and/or by converting an ineffective short wavelength light of at most 400 nm into an effective wavelength light of from 400 to 1,100 nm (hereinafter this conversion will sometimes be referred to as down conversion).

In a case where zinc oxide is used for the transparent electrically conductive layer in a compound semiconductor solar cell, a light of at most 360 nm will not reach the photoelectric conversion layer. Further, in a case where cadmium sulfide is used for the buffer layer, a light of at most 500 nm will not reach the photoelectric conversion layer. Accordingly, even a light in a wavelength region which can be photoelectrically converted becomes an ineffective wavelength light when absorbed by the transparent electrically conductive layer and/or the buffer layer, and accordingly it is possible to improve the power generation efficiency of a solar cell by wavelength conversion into an effective wavelength light before being absorbed.

Further, a solar cell has a distribution in the intensity of light depending on the wavelength with a peak at a wavelength in the vicinity of 550 nm. On the other hand, the photoelectric conversion efficiency of a solar cell has wavelength dependence depending on the band gap of the photoelectric conversion material. Therefore, the photoelectric conversion efficiency of a solar cell under the sunlight has wavelength dependence, and a crystalline silicon solar cell shows a maximum conversion efficiency at from 600 to 800 nm. Accordingly, the wavelength conversion material is more preferably a phosphor which emits light at a wavelength at which the photoelectric conversion efficiency of a solar cell is highest.

The average reflectance of the translucent laminated film of the present invention to light is preferably from 0 to 5%, more preferably from 0 to 3%, further preferably from 0 to 2%, in the effective wavelength region by the photoelectric conversion layer to be used, as the average of reflectances every 5 nm on the light receiving surface of the translucent laminated film as measured based on JIS R3106. Further, the average reflectance of the translucent laminated film to light measured in the same manner as above, is preferably from 0 to 5% in the ineffective wavelength region by the photoelectric conversion layer to be used.

Further, the average reflectance of the translucent laminated film to light measured in the same manner as above is preferably at most 5% to a light having a wavelength of from 300 to 400 nm and is preferably at most 2% to a light having a wavelength of from 400 to 1,200 nm.

The haze of the translucent laminated film of the present invention is preferably from 0 to 1%, more preferably from 0 to 0.5%, further preferably from 0 to 0.3%, in the effective wavelength region by the photoelectric conversion layer to be used, as the average of hazes on the light receiving surface of the translucent laminated film as measured based on JIS K7105. The haze can be measured, for example, by Hazeguard Plus manufactured by BYK-Gardner.

Hereinafter, the average transmittance to light, the average reflectance to light and the haze employed in this specification are respectively ones measured by the above methods. Unless otherwise specified, the transmittance to light is with respect to light which is transmitted from the light receiving surface side to the non-light receiving surface side of each member, and the reflectance to light and the haze are the reflectance to light and the haze on the light receiving surface of each member.

With respect to the wavelength conversion function of the translucent laminated film of the present invention, the translucent laminated film has a wavelength conversion function to convert a light in a wavelength region in which the photoelectric conversion efficiency by the photoelectric conversion layer for which the translucent laminated film of the present invention is to be used is low (i.e. the ineffective wavelength region) into a light in a wavelength region in which the photoelectric conversion efficiency is high (i.e. the effective wavelength region), and the wavelength region depends on the photoelectric conversion layer for which the translucent laminated film is to be used. For example, in a case where the photoelectric conversion layer is a solar cell, in the present invention, the wavelength conversion film of the translucent laminated film is designed in conformity with the corresponding wavelength region as described hereinafter so as to efficiently carry out the wavelength conversion, although it depends on the type such as a crystalline silicon solar cell, a CIGS compound type solar cell, a CdTe compound type solar cell or an amorphous silicon, organic or dye-sensitized solar cell, as mentioned above.

With respect to the translucent laminated films according to the first to third embodiments of the present invention, the wavelength region to be wavelength-converted is not limited to one region.

When the translucent laminated film of the present invention comprises a film having a wavelength conversion function on the light receiving surface side of the translucent substrate, specifically, a substrate front side wavelength conversion film according to the first embodiment or the optical functional film according to the third embodiment, the wavelength conversion function is a wavelength conversion function to absorb a light in the ineffective wavelength region which includes a light in a wavelength region in which the transmittance through at least the translucent substrate is low (hereinafter referred to as "light in a first wavelength region") and convert it into a light in the effective wavelength region to emit light.

Here, the "substrate front side" of the substrate front side wavelength conversion film means that the wavelength conversion film is provided on the light receiving surface side of the translucent substrate, as evident from the after-mentioned positional relation. Likewise, the "substrate rear side" of the substrate rear side wavelength conversion film means that the wavelength conversion film is provided on the non-light receiving surface side of the translucent substrate.

When the translucent laminated film of the present invention comprises a film having a wavelength conversion function on the non-light receiving surface side of the translucent substrate, specifically, the substrate front side wavelength conversion film or the optical functional film according to the first to third embodiments, the wavelength conversion function is a wavelength conversion function to absorb a light in the ineffective wavelength region which has passed through the translucent substrate (hereinafter referred to as "light in a second wavelength region") and convert it to a light in the effective wavelength region to emit light.

Further, depending on the photoelectric conversion layer for which the translucent laminated film of the present invention is to be used, the translucent laminated film may have another wavelength conversion film as the case requires, and in such a case, the translucent laminated film can be properly designed depending on the required properties within a range of the constitution of the present invention and not to impair the effects.

Now, the layer constitution of the translucent laminated films according to the first to third embodiments of the present invention will be described.

The translucent laminated film according to the first embodiment of the present invention comprises, in order from the light receiving surface side of the photoelectric conversion layer, the following constituents.
(a) A translucent substrate which protects the photoelectric conversion layer (hereinafter referred to as translucent substrate (a))
(b) A substrate front side wavelength conversion film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, in other word, a wavelength conversion function to convert a light in a first wavelength region into a light in the effective wavelength region (hereinafter referred to as a substrate front side wavelength conversion film (b)).
(c) An antireflection film which reduces reflection of the received light (hereinafter referred to as an antireflection film (c)).

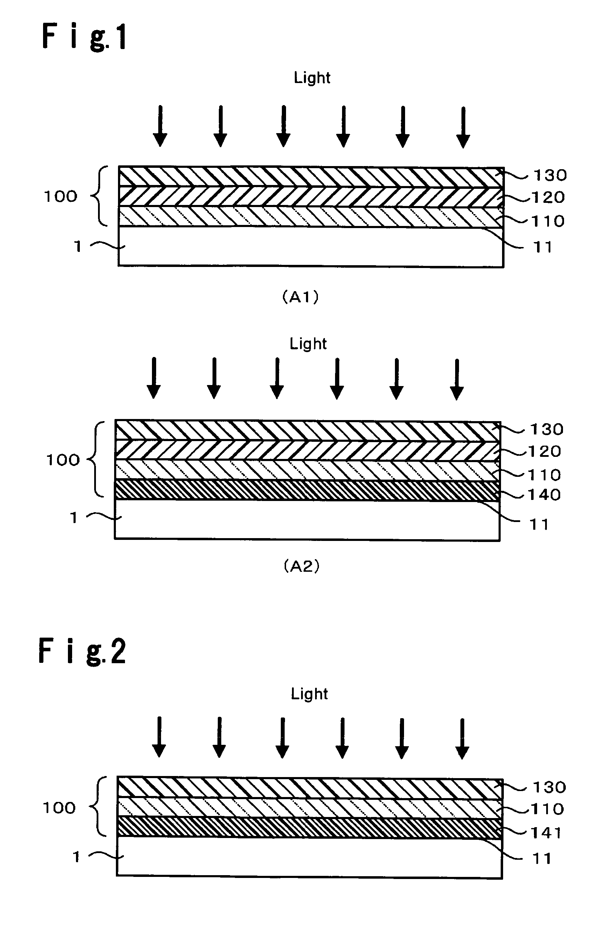

Fig. 1 is a cross sectional view illustrating an example of a translucent laminated film according to the first embodiment of the present invention. In Fig. 1 (A1), on a light receiving surface 11 side of a photoelectric conversion layer 1, a translucent laminated film 100 having translucent substrate (a) 110/substrate front side wavelength conversion film (b) 120/antireflection film (c) 130 laminated in order from the light receiving surface 11 side, is provided.

The translucent laminated film according to the first embodiment of the present invention preferably further has (d) a substrate rear side wavelength conversion film having a wavelength conversion function to convert a light in a wavelength region in which the photoelectric conversion efficiency by the photoelectric conversion layer is low, which has passed through the transmitted substrate, into a light in a wavelength region in which the photoelectric conversion efficiency is high, in other word, a wavelength conversion function to convert a light in a second wavelength region into a light in the effective wavelength region (hereinafter referred to as a substrate rear side wavelength conversion film (d)), on the photoelectric conversion layer side of the translucent substrate.

Fig. 1(A2) is a cross sectional view illustrating an example of a translucent laminated film according to a first embodiment having the substrate rear side wavelength conversion film (d). In Fig. 1(A2), on a light receiving surface 11 side of a photoelectric conversion layer 1, a translucent laminated film 100 having substrate rear side wavelength conversion film (d) 140/translucent substrate (a) 110/substrate front side wavelength conversion film (b) 120/antireflection film (c) 130 laminated in order from the light receiving surface 11 side, is provided.

The translucent laminated film according to the second embodiment of the present invention comprises the following constituents laminated in order from the light receiving surface side of the photoelectric conversion layer.
(d') A substrate rear side wavelength conversion film (d') having a wavelength conversion function to convert a light in a wavelength region in which the photoelectric conversion efficiency by the photoelectric conversion layer is low, which has passed through the following translucent substrate, into a light in a wavelength region in which the photoelectric conversion efficiency is high, and having an average refractive index to a light having a wavelength of from 300 to 1,000 nm in the film thickness direction of from 1.2 to 2.0 (hereinafter referred to as a substrate rear side wavelength conversion film (d')).
(a) A translucent substrate which protects the photoelectric conversion layer (the translucent substrate according to the second embodiment is the same as the translucent substrate (a) according to the first embodiment, and hereinafter the translucent substrate according to the second embodiment will also be referred to as a translucent substrate (a)).
(c) An antireflection film which reduces reflection of the received light (the antireflection film according to the second embodiment is the same as the antireflection film (c) according to the first embodiment, and hereinafter the antireflection film according to the second embodiment will also be referred to as an antireflection film (c)).

Fig. 2 is a cross sectional view illustrating an example of a translucent laminated film according to the second embodiment of the present invention. In Fig. 2, on a light receiving surface 11 side of a photoelectric conversion layer 1, a translucent laminated film 100 having substrate rear side wavelength conversion film (d') 141/translucent substrate (a) 110/antireflection film (c) 130 laminated in order from the light receiving surface 11 side, is provided.

The translucent laminated film according to a third embodiment of the present invention comprises the following constituents laminated in order from the light receiving surface side of the photoelectric conversion layer.
(a) A translucent substrate which protects the photoelectric conversion layer (the translucent substrate according to the third embodiment is the same as the translucent substrate (a) according to the first embodiment, and hereinafter the translucent substrate according to the third embodiment will also be referred to as a translucent laminated film (a)).
(e) An optical functional film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, in other word, a wavelength conversion function to convert a light in a first wavelength region into a light in the effective wavelength region, and having an antireflection function to reduce reflection of the received light (hereinafter referred to as an optical functional film (e)).

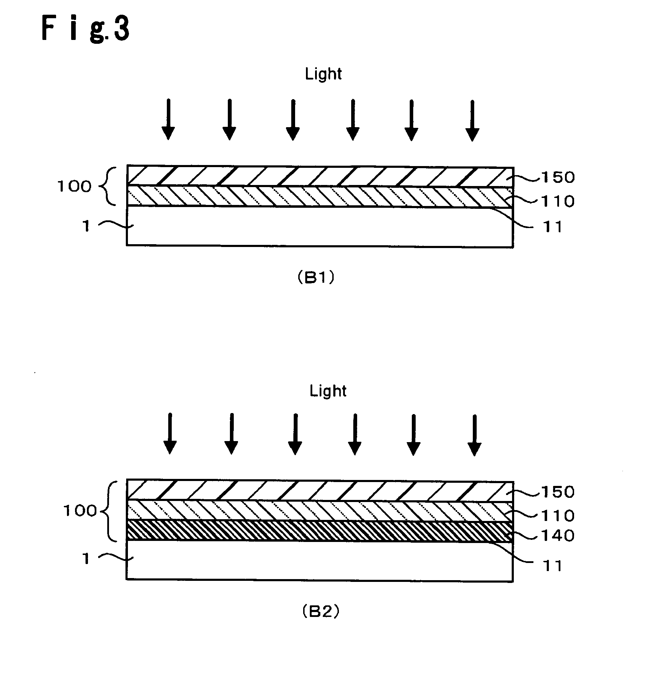

Fig. 3 is a cross sectional view illustrating an example of a translucent laminated film according to the third embodiment of the present invention. In Fig. 3(B1), on a light receiving surface 11 side of a photoelectric conversion layer 1, a translucent laminated film 100 having translucent substrate (a) 110/optical functional film (e) 150 laminated in order from the light receiving surface 11 side, is provided.

The translucent laminated film according to the third embodiment of the present invention, like the translucent laminated film according to the above first embodiment, preferably further has (d) a substrate rear side wavelength conversion film having a wavelength conversion function to convert a light in a wavelength region in which the photoelectric conversion efficiency by the photoelectric conversion layer is low, which has passed through the translucent substrate, into a light in a wavelength region in which the photoelectric conversion efficiency is high, in other word, a wavelength conversion function to convert a light in a second wavelength region into a light in the effective wavelength region (hereinafter referred to as a substrate rear side wavelength conversion film (d) in the same manner as the substrate rear side wavelength conversion film according to the first embodiment).

Fig. 3(B2) is a cross sectional view illustrating an example of the translucent laminated film according to the third embodiment having the substrate rear side wavelength conversion film (d). In Fig. 3(B2), on a light receiving surface 11 side of a photoelectric conversion layer 1, a translucent laminated film 100 having substrate rear side wavelength conversion film (d) 140/translucent substrate (a) 110/optical functional film (e) 150 laminated in order from the light receiving surface 11 side, is provided.

Here, in a case where the translucent laminated film according to the first or third embodiment of the present invention has the above substrate rear side wavelength conversion film, with a view to effectively converting the light in a long wavelength region in the ineffective wavelength region which can not be completely absorbed by the substrate front surface wavelength conversion film, by the substrate rear side wavelength conversion film, the wavelength at the light absorption long wavelength end in the first wavelength region is preferably shorter than the wavelength at the light absorption long wavelength end in the second wavelength region.

Usually, broadening the wavelength region capable of conversion by a single wavelength conversion film has not so high effect despite a complicated production process or the like. Accordingly, conversion of light in a wide wavelength region is carried out by using two or more wavelength conversion films differing in the wavelength region capable of conversion in combination. With respect to the substrate front side wavelength conversion film and the substrate rear side wavelength conversion film in the translucent laminated film of the present invention, although it depends on the optical characteristics of the translucent substrate to be used, the substrate front side wavelength conversion film preferably has a function to convert a light in a low wavelength region which is a wavelength region in which the transmittance of the translucent substrate is low among light in the ineffective wavelength region, into a light in the effective wavelength region. Accordingly, the substrate rear side wavelength conversion film to be combined therewith preferably has a wavelength conversion function to convert a light in a long wavelength region in the ineffective wavelength region which can not completely be absorbed by the substrate front side wavelength conversion film, into a light in the effective wavelength region.

Now, the respective constituents constituting the translucent laminated films according to the first to third embodiments of the present invention will be described.

### <Translucent substrate (a)>

The translucent substrate (a) to be used in the translucent laminated film of the present invention is not particularly limited so long as it is a translucent substrate constituted by a material having a high light transmittance. The degree of the light transmittance required depends on the photoelectric conversion layer for which the translucent laminated film is to be used, and in the effective wavelength region of the photoelectric conversion layer to be used, specifically, in the above-mentioned effective wavelength region of each photoelectric conversion layer, it is preferably from 80 to 100%, more preferably from 90 to 100%, further preferably from 91 to 100%.

Further, the haze is preferably from 0 to 1%, more preferably from 0 to 0.5%, further preferably from 0 to 0.3%, in the effective wavelength region of the photoelectric conversion layer to be used, specifically, in the above-mentioned effective wavelength region of each photoelectric conversion layer.

Further, when the translucent laminated film of the present invention is used, for example, for a crystalline silicon solar cell, the average transmittance of the translucent substrate at from 300 to 400 nm which is a preferred range of the ineffective wavelength, is preferably at least 70%, more preferably at least 75%. If the average transmittance is low in the ineffective wavelength region, in a case where the substrate rear side wavelength conversion film is formed on the non-light receiving surface side of the translucent substrate, the amount of light which reaches the substrate rear side wavelength conversion film is small, and no sufficient wavelength conversion effect is likely to be obtained.

The average refractive index n1 to the translucent substrate (a) to a light having a wavelength of from 300 to 1,000 nm in its thickness direction is preferably at least the average refractive index n2 of the substrate front side wavelength conversion film (b) and at least the average refractive index n3 of the antireflection film (c) as mentioned above. The average refractive index n1 of the translucent substrate (a) to a light having a wavelength of from 300 to 1,000 nm in its thickness direction is, although it depends on the materials constituting the substrate front side wavelength conversion film (b) and the antireflection film (c), specifically preferably from 1.46 to 1.60, more preferably from 1.48 to 1.55. In this specification, the average refractive index is an average of the refractive index values at wavelengths every 5 nm measured on the light receiving surface side of each member.

The shape of the translucent substrate (a) is usually e.g. a plate, film or lens shape which is the shape of a surface protective layer to be used for the photoelectric conversion layer, although it depends on the shape of the photoelectric conversion layer on which it is to be provided. E.g. a condenser lens or glass having an antireflection structure formed on the light receiving surface side may also be used as the translucent substrate (a). The thickness of the translucent substrate (a) depends on the photoelectric conversion layer to be used and the light transmission property of the translucent substrate (a) and is preferably approximately from 0.1 to 10 mm.

Further, the translucent substrate (a) may have concavo-convex shape on the front surface and/or the rear side. It is preferred to form the wavelength conversion material layer on a concave portion, whereby the relatively high refractive index (about 2) of the wavelength conversion film is relaxed by the translucent substrate (a) (for example, about 1.52 in the case of glass). The concavo-convex structure may be specifically a diameter of from 100 to 1,000 µm, a depth of from 20 to 200 µm and a concavo-convex pitch of from 100 to 1,000 µm. The concavo shape may, for example, be a triangular pyramid, a quadrangular pyramid, a circular cone, a hemisphere, a parabola, an inverted parabola or a slit. The structure of the translucent substrate (a) is more preferably such that within the above preferred range of the average refractive index, the refractive index is reduced from the side opposite to the light receiving surface i.e. the non-light receiving surface side toward the light receiving surface side. Further, the translucent substrate (a) may have a wavelength conversion material in its interior.

In such a case, it is preferred that (the wavelength at the light absorption long wavelength end in the first wavelength region) ≦ (the wavelength at the light absorption long wavelength end in the wavelength region converted by the wavelength conversion function of the translucent substrate) ≦ (the wavelength at the light absorption long wavelength end in the second wavelength region).

A material having a high light transmittance, capable of constituting the translucent substrate (a), may, for example, be specifically glass, a translucent resin or a translucent ceramic. As the glass, not only glass formed by a float process or the like, but also figured glass obtainable by a roll-out process by supplying molten glass between a roll member having concavo-convex impressed on its surface and another roll member, or laminated glass having at least two sheets of glass bonded by a resin may be used. As the material of glass, an inorganic glass material such as soda lime glass, borosilicate glass, alkali-free glass or quartz glass may be mentioned.

As the translucent resin, an organic polymer having translucency may be used without any particular restriction. The organic polymer may, for example, be specifically polyethylene terephthalate (hereinafter referred to as PET), polycarbonate, polymethyl methacrylate, triacetyl acetate or a fluororesin (such as ETFE).

The average refractive index of such a translucent resin to a light having a wavelength of from 300 to 1,000 nm in the thickness direction is approximately within a range of from 1.34 to 1.61, and the average refractive index of the above inorganic glass under the same conditions is about 1.52. In the present invention, considering the weather resistance, as the material constituting the translucent substrate (a), inorganic glass is preferred, but for applications for which flexibility is required or for indoor use, a translucent resin may be used.

As examples of the constitution unit of inorganic glass, including compositions unstable as a single substance, an alkali metal oxide such as lithium oxide (Li₂O), sodium oxide (Na₂O), potassium oxide (K₂O), rubidium oxide (Rb₂O) or cesium oxide (Cs₂O), an oxide of a bivalent to hexavalent element such as boron oxide (B₂O₃), aluminum oxide (Al₂O₃), silicon oxide (SiO₂), phosphorus oxide (P₂O₅), titanium oxide (TiO₂), zinc oxide (ZnO), gallium oxide (Ga₂O₃), germanium oxide (GeO₂), zirconium oxide (ZrO₂), cadmium oxide (CdO), tellurium oxide (TeO₂), barium oxide (BaO), tungsten oxide (WO₃), tantalum oxide (Ta₂O₅), lead oxide (PbO) or bismuth oxide (Bi₂O₃), an alkali metal fluoride such as lithium fluoride (LiF), sodium fluoride (NaF), potassium fluoride (KF), rubidium fluoride (RbF) or cesium fluoride (CsF), a fluoride of a bivalent to tetravalent element such as beryllium fluoride (BeF₂), magnesium fluoride (MgF₂), aluminum fluoride (AIF₃), calcium fluoride (CaF₂), scandium fluoride (ScF₃), manganese fluoride (MnF₂), iron fluoride (FeF₂, FeF₃), cobalt fluoride (CoF₂), nickel fluoride (NiF₂), zinc fluoride (ZnF₂), gallium fluoride (GaF₃), strontium fluoride (SrF₂), yttrium fluoride (YF₃), zirconium fluoride (ZrF₄), cadmium fluoride (CdF₂), indium fluoride (InF₃), barium fluoride (BaF₂), lanthanum fluoride (LaF₃), neodyminum fluoride (NdF₃), ytterbium fluoride (YbF₃), lead fluoride (PbF₂) or thorium fluoride (ThF₄), a 4B group element such as gallium (Ga) or germanium (Ge), a 5B group element such as phosphorus (P), arsenic (As) or antimony (Sb), or a 6B group element such as sulfur (S), selenium (Se) or tellurium (Te) may, for example, be mentioned.

Further, a typical inorganic glass composition may, for example, be, as disclosed in Ceramics International, MacFarlane, D. R., vol. 22, page 533 (1996), an oxide glass such as SiO₂, GeO₂, TeO₂-BaO-ZnO, TeO₂-WO₃-Ta₂O₅, TeO₂-WO₃-Bi₂O₃, TeO₂-BaO-PbO, CaO-Al₂O₃, CaO-Al₂O₃-BaO, CaO-Al₂O₃-Na₂O, CaO-Al₂O₃-K₂O₃, CaO-Al₂O₃-SiO₂, PbO-Bi₂O₃-BaO, PbO-Bi₂O₃-ZnO, PbO-Bi₂O₃, PbO-Bi₂O₃-BaO-ZnO, PbO-Bi₂O₃-CdO-Al₂O₃, PbO-Bi₂O₃-GeO₂, PbO-Bi₂O₃-GeO₂-Tl₂O, BaO-PbO-Bi₂O₃, BaO-PbO-Bi₂O₃-ZnO, Bi₂O₃-Ga₂O₃-PbO, Bi₂O₃-Ga₂O₃-CdO or Bi₂O₃-Ga₂O₃-(Pb,Cd)O, a zirconium fluoride glass such as ZrF₄-BaF₂, ZrF₄-ThF₄, ZrF₄-BaF₂-NaF, ZrF₄-BaF₂-ThF₄, ZrF₄-BaF₂-LaF₃, ZrF₄-BaF₂-MFₙ-AIF₃ (wherein MFₙ is LiF, NaF, CaF₂, YF₃, GaF₃, LaF₃, NdF₃, ThF₄ or the like), or ZrF₄-BaF₂-LaF₃-AIF₃-NaF (common name: ZBLAN), an aluminum fluoride glass such as AIF₃-PbF₂-SrF₂-MgF₂, AIF₃-BaF₂-YF₃-ThF₄, AIF₃-YF₃-BaF₂-CaF₂ or AIF₃-CdF₂-LiF-PbF₂, a trifluoride glass such as PbF₂-MF₂-XF₃, AF-MF₂-XF₃ (wherein A is an alkali metal, and each of M and X which are independent of each other, is a transition metal such as iron, cobalt or nickel) or InF₃-BaF₂-YF₃, a bivalent metal fluoride glass comprising ZnF₂, SrF₂, MnF₂, CaF₂, BaF₂ or the like as the base, a chalcogenide glass such as As-S, Ge-S, Ge-P-S, As-Se, As-Ge-Se, Ge-Se, Ge-As-Se, La-Ga-Ge-Se, Ge-Sb-Se, Ge-Se-Te, As-Ge-Se-Te or As-Se-Te, a chalcohalide glass such as TeCl₄, TeBr₄ or Tel₄, boron nitride glass, or soda lime glass such as SiO₂-Al₂O₃-CaO-MgO-Na₂O. The soda lime glass is preferably a highly transmitting glass having an iron content of at most 0.05%.

### <Substrate front side wavelength conversion film (b)>

In the translucent laminated film according to the first embodiment of the present invention, the substrate front side wavelength conversion film (b) is provided on the light receiving surface side of the translucent substrate (a).

The substrate front side wavelength conversion film (b) to be used in the present invention has a wavelength conversion function to convert a light in the ineffective wavelength region by the photoelectric conversion layer for which the translucent laminated film of the present invention is to be used, which includes a light in a wavelength region in which the transmittance through at least the translucent substrate is low (i.e. the light in a first wavelength region) into a light in the effective wavelength region. The light in the effective wavelength region obtainable by the wavelength conversion is usually a light in a wavelength region in which the transmittance through the translucent substrate is high.

The first wavelength region and the effective wavelength region vary depending on the photoelectric conversion layer for which the translucent laminated film of the present invention is to be used. Approximately, the first wavelength region is preferably a wavelength region of at most 400 nm, and the effective wavelength region is preferably a wavelength region with a peak at a wavelength of at least 400 nm. Further, the substrate front side wavelength conversion film can be prepared by the after-mentioned method by properly selecting the after-mentioned wavelength conversion material in conformity with the photoelectric conversion layer.

The ineffective wavelength region and the effective wavelength region depend on the photoelectric conversion layer for which the translucent laminated film is to be used, as described above, and the ineffective wavelength region and the effective wavelength region in each photoelectric conversion layer are as described above. The light in a first wavelength region is a light in the ineffective wavelength region by the photoelectric conversion layer, which includes a light in a wavelength region in which the transmittance through at least the translucent substrate is low. A wavelength region in which the transmittance through the translucent substrate is low varies depending on the translucent substrate. Further, a low transmittance means a relatively low transmittance as compared with the other wavelength regions. For example, in the case of glass, a wavelength region of approximately from 200 to 350 nm can be considered to be a low wavelength region. In a case where the translucent substrate is a transparent resin, for example, the wavelength region in which the transmittance is low is a wavelength region of from 200 to 400 nm in the case of PET, from 200 to 350 nm in the case of polycarbonate, from 200 to 380 nm in the case of polymethyl methacrylate, from 200 to 350 nm in the case of triacetyl acetate, or at most 200 nm in the case of a fluororesin (such as ETFE).

As mentioned above, the wavelength of light which is wavelength-converted by the substrate front side wavelength conversion film (b), i.e. the first wavelength region, is properly selected depending on the photoelectric conversion layer and the translucent substrate to be used. Further, the wavelength region obtainable after the wavelength conversion (hereinafter referred to as "third wavelength region") is properly selected within a range of the effective wavelength region as exemplified above depending on the wavelength conversion efficiency required for the photoelectric conversion layer.

Now, the first wavelength region and the third wavelength region will be described with reference to a case where the photoelectric conversion layer is a solar cell as an example. For example, in the case of a crystalline silicon solar cell, the first wavelength region is preferably from 200 to 400 nm and/or from 1,100 to 4,000 nm, more preferably from 300 to 350 nm and/or from 1,200 to 2,400 nm. The third wavelength region is preferably from 400 to 1,100 nm, more preferably from 500 to 900 nm, further preferably from 600 to 800 nm.

In the case of use as a CIGS compound type solar cell, the first wavelength region is preferably from 200 to 400 nm and/or from 1,200 to 4,000 nm, more preferably from 300 to 350 nm and/or from 1,300 to 2,400 nm. The third wavelength region is preferably from 400 to 1,200 nm, more preferably from 500 to 1,000 nm, further preferably from 600 to 900 nm.

In the case of use as a CdTe compound type solar cell, the first wavelength region is preferably from 200 to 400 nm and/or from 1,200 to 4,000 nm, more preferably from 300 to 350 nm and/or from 1,300 to 2,400 nm. The third wavelength region is preferably from 400 to 1,200 nm, more preferably from 500 to 1,000 nm, further preferably from 600 to 900 nm.

In the case of use as an amorphous silicon, organic or dye-sensitized solar cell, the first wavelength region is preferably from 200 to 350 nm and/or from 750 to 4,000 nm, more preferably from 300 to 350 nm and/or from 800 to 2,400 nm. The third wavelength region is from 350 to 750 nm, more preferably from 450 to 650 nm, further preferably from 500 to 600 nm.

The average refractive index n2 of the substrate front side wavelength conversion film (b) to be used in the present invention to a light having a wavelength of from 300 to 1,000 nm in the film thickness direction is preferably from 1.2 to 2.0, more preferably from 1.25 to 1.8, further preferably from 1.3 to 1.6. If the average refractive index is lower than 1.2, the refractive index difference with the translucent substrate (a) tends to be large, and the reflectance at the interface between the translucent substrate (a) and the substrate front side wavelength conversion film (b) tends to be high, whereby the effect of improving the power generation of the photoelectric conversion layer by the first wavelength conversion will substantially be reduced. If the average refractive index is higher than 2.0, the refractive index difference with the after-mentioned antireflection film tends to be significant, and the reflectance at the interface between the antireflection film and the substrate front side wavelength conversion film (b) tends to be high, whereby the effect of improving the power generation efficiency of the photoelectric conversion layer by the first wavelength conversion will significantly be reduced.

The refractive index of the substrate front side wavelength conversion film (b) may be uniform or may have distribution in the film preferably within the above range of the average refractive index. In a case where it has distribution, preferred is such distribution that the refractive index is gradually reduced from the non-light receiving surface toward the light receiving surface, whereby the reflectance can be suppressed to be low in a wide wavelength region.

The thickness of the substrate front side wavelength conversion film (b) is preferably from 20 to 20,000 nm, more preferably from 30 to 10,000 nm, further preferably from 50 to 5,000 nm. If the thickness is smaller than 20 nm, the absorptivity to a light in the ineffective wavelength region, specifically, a light in the above-mentioned ineffective wavelength region of each photoelectric conversion layer, tends to be low, and the conversion ratio into a light in the effective wavelength region, specifically, a light in the above-mentioned effective wavelength region of each photoelectric conversion layer, is low in some cases, whereby no sufficient effect of improving the power generation efficiency of the photoelectric conversion layer by the substrate front side wavelength conversion film (b) may be obtained. Further, if the thickness is thicker than 20,000 nm, cracking may occur, thus leading to a decrease in the film strength.

The surface shape of the substrate front side wavelength conversion film (b) may be flat or may be a concavo-convex shape. In a case where the substrate front side wavelength conversion film (b) has a concavo-convex shape and is in contact with the antireflection film (c), a refractive index gradient is preferably formed at the interface therebetween, whereby the reflectance at the interface will be lowered. However, if the concavo-convex is too significant, light scattering at the film interface may occur, whereby the incident light tends to be reduced. The average surface roughness of he substrate front side wavelength conversion film is preferably from 10 to 500 nm, more preferably from 20 to 400 nm, further preferably from 30 to 300 nm.

If the substrate front side wavelength conversion film (b) absorbs light in the effective wavelength region by the photoelectric conversion layer to be used, specifically, in the above-mentioned effective wavelength region of each photoelectric conversion layer, the power generation efficiency of the photoelectric conversion layer tends to be reduced, such being unfavorable.

The average transmittance of the substrate front side wavelength conversion film to a light in the effective wavelength region, specifically, in the above-mentioned effective wavelength region of each photoelectric conversion layer, is preferably from 90 to 100%, more preferably from 92 to 100%, further preferably from 93 to 100%.

### <Substrate rear side wavelength conversion film (d)>

In the translucent laminated film according to the first or third embodiment of the present invention, the substrate rear side wavelength conversion film (d) is provided on the non-light receiving surface side of the translucent substrate (a) as shown in Fig. 1 (A2) or Fig. 3(B2) for example. Further, the substrate rear side wavelength conversion film (d) may also be provided at a position in contact with the light receiving surface of the photoelectric conversion layer. In such a case, the function of the substrate rear side wavelength conversion film (d) may be imparted to a sealing layer or a transparent electrode located on the light receiving surface side of the photoelectric conversion layer.

Here, the substrate rear side wavelength conversion film (d') in the translucent laminated film according to the second embodiment may be all the same as the substrate rear side wavelength conversion film (d) in the translucent laminated film according to the first or third embodiment, except that the average refractive index to a light having a wavelength of from 300 to 1,000 nm in the film thickness direction is from 1.2 to 2.0. Hereinafter, unless otherwise specified, the substrate front side wavelength conversion film includes both the substrate rear side wavelength conversion film (d) according to the first or third embodiment and the substrate rear side wavelength conversion film (d') according to the second embodiment.

The substrate rear side wavelength conversion film to be used in the present invention has a wavelength conversion function to convert a light in the ineffective wavelength region which has passed through the translucent substrate (i.e. a light in the second wavelength region) into a light in a wavelength region in which the photoelectric conversion efficiency by the photoelectric conversion layer to be used is high. Here, the wavelength region obtainable by wavelength conversion by the substrate rear side wavelength conversion film (hereinafter referred to as "fourth wavelength region") is properly selected within a range of the above-exemplified effective wavelength region depending on the wavelength conversion efficiency required for the photoelectric conversion layer.

The second wavelength region varies depending on the photoelectric conversion layer for which the translucent laminated film of the present invention is to be used and the translucent substrate, and as described above, the wavelength at the light absorption long wavelength end in the second wavelength region is preferably longer than the wavelength at the light absorption long wavelength end in the first wavelength region, with a view to effectively converting a light in the long wavelength region in the ineffective wavelength region which cannot completely be absorbed by the substrate front side wavelength conversion film designed to convert a light in a relatively short wavelength region in the ineffective wavelength region, by the substrate rear side wavelength conversion film.

The fourth wavelength region may be the same as the third wavelength region in the substrate front side wavelength conversion film (b). However, the third wavelength region and the fourth wavelength region may be different within the above range depending upon the substrate front side wavelength conversion film (b) and the substrate rear side wavelength conversion film to be used.

Further, the substrate rear side wavelength conversion film can be prepared by the after-mentioned method by properly selecting the after-mentioned wavelength conversion material in conformity with the photoelectric conversion layer.

Now, the second wavelength region will be described with reference to a case where the photoelectric conversion layer is a solar cell as an example. For example, in the case of a crystalline silicon solar cell, the second wavelength region is from 300 to 450 nm and/or from 1,100 to 4,000 nm, more preferably from 320 to 400 nm and/or from 1,200 to 2,400 nm.

In the case of a CIGS compound type solar cell, the second wavelength region is from 300 to 450 nm and/or from 1,200 to 4,000 nm, more preferably from 320 to 400 nm and/or from 1,300 to 2,400 nm.

In the case of a CdTe compound type solar cell, the second wavelength region is from 300 to 450 nm and/or from 1,200 to 4,000 nm, more preferably from 320 to 400 nm and/or from 1,300 to 2,400 nm.

In the case of an amorphous silicon, organic or dye-sensitized solar cell, the second wavelength region is from 300 to 380 nm and/or from 750 to 4,000 nm, more preferably from 320 to 350 nm and/or from 800 to 2,400 nm.

The average refractive index of the substrate rear side wavelength conversion film (d) to be used in the present invention to a light having a wavelength of from 300 to 1,000 nm in the film thickness direction is preferably from 1.2 to 2.0, more preferably from 1.25 to 1.8, further preferably from 1.3 to 1.7. The average refractive index of the substrate rear side wavelength conversion film (d') to a light having a wavelength of from 300 to 1,000 nm in the film thickness direction is from 1.2 to 2.0, preferably from 1.25 to 1.8, more preferably from 1.3 to 1.7.

If the average refractive index is lower than 1.2, the refractive index difference with the translucent substrate (a) tends to be large, and in a case where there is an interface between the translucent substrate (a) and the substrate rear side wavelength conversion film, the reflectance at the interface tends to be high, whereby the effect of improving the power generation efficiency of the photoelectric conversion layer by the second wavelength conversion will remarkably be reduced. If the average refractive index is higher than 2.0, in a case where there is an interface between the photoelectric conversion layer and the substrate rear side wavelength conversion film, the refractive index difference with a transparent electrode or a sealing material of the photoelectric conversion layer tends to be large, and the reflectance at the interface tends to be high, whereby the effect of improving the power generation efficiency of the photoelectric conversion layer by the second wavelength conversion will remarkably be reduced.

The refractive index of the substrate rear side wavelength conversion film may be uniform or may have distribution in the film, preferably within the above range of the average refractive index. In a case where it has distribution, preferred is distribution such that the refractive index is gradually reduced from the non-light receiving surface side toward the light receiving surface side, whereby the reflectance can be suppressed to be low in a wide wavelength region.

Further, when the translucent substrate (a) has concavo-convex, the refractive index of the substrate rear side wavelength conversion film (d) is relaxed by the translucent substrate (a), such being favorable, and when it has a concavo-convex structure such that the volume of the translucent substrate increases toward the light source, the refractive index is gradually reduced toward the light source, such being more favorable.

The thickness of the substrate rear side wavelength conversion film is preferably from 20 to 20,000 nm, more preferably from 30 to 10,000 nm, further preferably from 50 to 5,000 nm. If the thickness is thicker than 20 nm, the absorptivity to a light in the ineffective wavelength region, specifically, a light in the above-mentioned ineffective wavelength region of each photoelectric conversion layer, tends to be low, and a conversion ratio into a light in the effective wavelength region, specifically, a light in the above-mentioned effective wavelength region of each photoelectric conversion layer is low in some cases, whereby no sufficient effect of improving the power generation efficiency of the photoelectric conversion layer by the substrate rear side wavelength conversion film may be obtained.

Further, if the thickness is thicker than 20,000 nm, cracking may occur, thus leading to a decrease in the film strength.

The surface shape of the substrate rear side wavelength conversion film may be flat or may be a concavo-convex shape. In a case where the film has a concavo-convex structure and is in contact with the antireflection film (c), when a refractive index gradient is formed on their interface, the reflectance at the interface is reduced, such being favorable. However, if the degree of concavo-convex is too significant, light scattering at the film interface may occur, whereby the incident light is reduced, such being unfavorable. The average surface roughness of the substrate rear side wavelength conversion film is preferably from 10 to 500 nm, more preferably from 20 to 400 nm, further preferably from 30 to 300 nm. However, in a case where the substrate rear side wavelength conversion film is adjacent to a transparent electrode of the photoelectric conversion layer for example and/or in a case where the transparent electrode also functions as the second wavelength conversion film, a relatively great concavo-convex structure exceeding the above range of the surface roughness may be formed.

If the substrate rear side wavelength conversion film absorbs a light in a wavelength region in which the photoelectric conversion efficiency by the photoelectric conversion layer to be used is high (i.e. the effective wavelength region), specifically, a light in the above-mentioned effective wavelength region of each photoelectric conversion layer, the power generation efficiency of the photoelectric conversion layer tends to be reduced, such being unfavorable.

The average transmittance of the substrate rear side wavelength conversion film to a light in the effective wavelength region, specifically a light in the above-mentioned effective wavelength region of each photoelectric conversion layer, is preferably from 90 to 100%, more preferably from 92 to 100%, more preferably from 93 to 100%.

Here, in a case where glass is used as the translucent substrate (a) for example, usually, glass absorbs a light having a wavelength of at most 350 nm. In such a case, it is preferred to provide the substrate front side wavelength conversion film (b) capable of converting a light having a wavelength of at most 350 nm into a light having a wavelength of at least 350 nm on the light receiving surface side of the glass which is the translucent substrate (a) according to the first embodiment of the present invention, and to provide the substrate rear side wavelength conversion film (d) which converts a light in a wavelength region in which the photoelectric conversion efficiency is low, having a wavelength of at least 350 nm, into a light in a wavelength region in which the photoelectric conversion efficiency is high, on the non-light receiving surface side of the glass which is the translucent substrate (a).

By doing so, it is possible to suitably improve the power generation efficiency of the photoelectric conversion layer to be used, in the case of a solar cell. Accordingly, in a case where glass is used as the translucent substrate (a), it is preferred that the substrate front side wavelength conversion film (b) effectively absorbs a light having a wavelength of from 200 to 350 nm, and the substrate rear side wavelength conversion film (d) effectively absorbs a light from a wavelength of 350 nm to the short wavelength end in a wavelength region in which the photoelectric conversion efficiency is high. Further, the average transmittance to a light having a wavelength of from 200 to 350 nm with respect to the substrate front side wavelength conversion film (b) and to a light from a wavelength of 350 nm to the short wavelength end in a wavelength region in which the photoelectric conversion efficiency is high with respect to the substrate rear side wavelength conversion film (d), is from 0 to 30%, more preferably from 0 to 20%, further preferably from 0 to 10%.

Also in a case where a transparent resin is used as the translucent substrate (a), in the same manner as in the case of glass, a substrate front side wavelength conversion film (b) which converse a light in the ineffective wavelength region by the photoelectric conversion layer, which includes a light in a wavelength region in which the transmittance at least through the translucent resin substrate is low (i.e. a light in the first wavelength region) into a light in the effective wavelength region in which the transmittance through the translucent resin substrate is high is provided on the light receiving surface side of the translucent resin substrate depending on the absorption wavelength of the resin, and a substrate rear side wavelength conversion film (d) which converts a light in the ineffective wavelength region which has passed through the translucent resin substrate (i.e. a light in the second wavelength region) into a light in the effective wavelength region is provided on the non-light receiving surface side.

Further, in a case where an organic resin such as EVA is used as a material constituting the translucent laminated film or the photoelectric conversion layer, for example, as a matrix resin to be used for the respective layers of the translucent laminated film or a sealing material of the photoelectric conversion layer, such an organic resin may undergo deterioration such as yellowing due to an ultraviolet light of from 200 to 400 nm. However, the ultraviolet light is absorbed by the substrate front side wavelength conversion film (b) and/or the substrate rear side wavelength conversion film, thus leading to a long life of the organic resin. The transmittance of the substrate front side wavelength conversion film (b) and/or the substrate rear side wavelength conversion film to a light having a wavelength of from 200 to 400 nm is preferably from 0 to 30%, more preferably from 0 to 20%, further preferably from 0 to 10%.

The translucent laminated film of the present invention may have a wavelength conversion film other than the above as the case requires. Such a wavelength conversion film may be the same as the substrate rear side wavelength conversion film except that it is designed to have a function to convert a light in the ineffective wavelength region other than the above first wavelength region and the second wavelength region into a light in the effective wavelength region.

### <Antireflection film (c)>

The antireflection film (c) to be used in the present invention has a function to reduce reflection of the received light. The antireflection film (c) particularly preferably has a function to reduce reflection of a light in the first wavelength region and a light in the second wavelength region.

According to the first and second embodiments of the present invention, the antireflection film (c) is provided as the outermost layer on a side where the received light enters, as mentioned above, among the constituents of the translucent laminated film. The antireflection film (c) may be a single layer film or a multilayer film.

By the function of the antireflection film (c), the reflection of light in all the wavelength regions of the received light is reduced, whereby the light in the effective wavelength region which directly reaches the photoelectric conversion layer is increased. In addition, the light in the ineffective wavelength region which reaches the substrate front side wavelength conversion film and/or the substrate rear side wavelength conversion film is increased, thereby to convert a larger amount of a light in the ineffective wavelength region into a light in the effective wavelength region, whereby the light in the effective wavelength region which reaches the photoelectric conversion layer is increased.

Here, by a conventional multilayer antireflection film comprising a low refractive index layer and a high refractive index layer, an antireflection function in the effective wavelength region can be imparted, however, the reflectance in the ineffective wavelength region is increased as compared with the translucent substrate, such being problematic. Accordingly, in the present invention, as the antireflection film, a layer having a lower refractive index than those of the translucent substrate and the wavelength conversion film, even though it is a high refractive index layer, is formed, so that the reflectance in the ineffective wavelength region can be suppressed to be low.

The average refractive index n3 of the antireflection film (c) to a light having a wavelength of from 300 to 1,000 nm in the film thickness direction is preferably from 1.1 to 1.5, more preferably from 1.15 to 1.4, further preferably from 1.2 to 1.35. If the average refractive index is higher than 1.5, the antireflection effect tends to be insufficient, and no sufficient effect of improving the power generation efficiency of the photoelectric conversion layer by wavelength conversion may be obtained. If the average refractive index is lower than 1.1, the porosity of the film is inevitably high, whereby no sufficient film strength may be obtained in some cases.

Of the translucent laminated film according to the first and second embodiments of the present invention, the relation between the average refractive indices of the substrate front side wavelength conversion film and the antireflection film (c) to a light having a wavelength of from 300 to 1,000 nm in the film thickness direction, is preferably such that the average refractive index of the substrate front side wavelength conversion film is at least the average refractive index of the antireflection film (c), and the average refractive index of the substrate front side wavelength conversion film and/or the antireflection film (c) to a light having a wavelength of from 300 to 1,000 nm in the film thickness direction is within a range of from 1.1 to 1.5.

In a case where the antireflection film (c) is constituted by at least three layers for example, assuming that it has a first layer, a second layer and a third layer in order from the side close to the translucent substrate (a), and the average refractive index of the first layer to a light having a wavelength of from 300 to 1,000 nm in the film thickness direction is N1, the average refractive index of the second layer N2 and the average refractive index of the third layer N3, these average refractive indices preferably satisfy the relation of N1>N3>N2. Specifically, the average refractive index N1 is preferably at most 1.50. The average refractive index N2 is preferably at most 1.30. The average refractive index N3 is preferably at most 1.40.

The refractive index of the antireflection film (c) may be uniform or may have distribution in the film, preferably within the above range of the average refractive index. When it has distribution, the distribution is preferably such that the refractive index is gradually reduced from the non-light receiving surface to the light receiving surface, whereby the reflectance can be suppressed to be low in a wide wavelength region.

If the antireflection film (c) absorbs a light in a wavelength region in which the photoelectric conversion efficiency by the photoelectric conversion layer to be used is high (i.e. the effective wavelength region), specifically, a light in the above-mentioned effective wavelength region of each photoelectric conversion layer, the power generation efficiency of the photoelectric conversion layer is decreased, such being unfavorable. Further, if it absorbs a light in a wavelength region in which the photoelectric conversion efficiency is low (i.e. the ineffective wavelength region), the amount of light which reaches the wavelength conversion film is reduced, whereby no sufficient effect of improving the power generation efficiency by the photoelectric conversion layer by wavelength conversion may be obtained in some cases, such being unfavorable.

The average transmittance of the antireflection film (c) to a light in the effective wavelength region, specifically, a light in the above-mentioned effective wavelength region of each photoelectric conversion layer, and to a light in the ineffective wavelength region, specifically, a light in the above-mentioned ineffective wavelength region of each photoelectric conversion layer, is preferably from 90 to 100%, more preferably from 92 to 100%, further preferably from 93 to 100%.

Further, as described above, the average reflectance on the light receiving surface of the antireflection film (c) constituting the outermost layer on the light receiving surface side of the translucent laminated film to a light in the effective wavelength region of the photoelectric conversion layer to be used, specifically, a light in the above-mentioned effective wavelength region of each photoelectric conversion layer, is preferably from 0 to 5%, more preferably from 0 to 3%, further preferably from 0 to 2%. Further, the average reflectance on the light receiving surface of the antireflection film (c) to a light having a wavelength of from 300 to 400 nm is preferably at most 5%. Further, the average reflectance on the light receiving surface of the antireflection film (c) to a light having a wavelength of from 400 to 1,200 nm is preferably at most 2%.

The thickness of the antireflection film (c) is preferably set so that the average reflectance to a light in the effective wavelength region and a light in the ineffective wavelength region is lowest, and is preferably from 80 to 1,000 nm, more preferably from 90 to 900 nm, further preferably from 100 to 800 nm.

The surface shape of the antireflection film (c) may be flat or may be a concavo-convex shape. When the refractive index is inclined by the concavo-convex structure, reflection can be prevented in a wide wavelength region, such being more favorable. The concavo-convex structure is specifically preferably a diameter of from 20 to 1,000 nm, a depth of from 50 to 2,000 nm and a concavo-convex pitch of from 20 to 1,000 nm. The concave shape may, for example, be a triangular pyramid, a quadrangular pyramid, a circular cone, a hemisphere, a parabola, an inverted parabola or a slit.

Further, the antireflection film (c) may be designed to have a wavelength conversion function to convert a light in a wavelength region in which the photoelectric conversion efficiency by the photoelectric conversion layer to be used is low, which includes a light in a wavelength region in which the transmittance through at least the translucent substrate is low (i.e. a light in the first wavelength region) into a light in a wavelength region in which the photoelectric conversion efficiency is high (i.e. the effective wavelength region). In such a case, usually the light in the effective wavelength region after the wavelength conversion is a light in a wavelength region in which the transmittance through the translucent substrate is high. Further, the structure of the antireflection film (c) having the wavelength conversion function imparted is the same as the following optical functional film (e).

### <Optical functional film (e)>

The optical functional film (e) to be used for the third embodiment of the present invention has both functions as the substrate front side wavelength conversion film and the antireflection film (c), and is provided on the outermost side where the received light enters among the constituents of the translucent laminated film.

The wavelength conversion function of the optical functional film (e) is totally the same as the wavelength conversion function as disclosed for the above substrate front side wavelength conversion film.

The average refractive index of the optical functional film (e) to a light having a wavelength of from 300 to 1,000 nm in the film thickness direction is preferably from 1.1 to 1.5, more preferably from 1.15 to 1.4, further preferably from 1.2 to 1.35. If the average refractive index is higher than 1.5, the antireflection effect tends to be insufficient, and no sufficient effect of improving the power generation efficiency of the photoelectric conversion layer by the wavelength conversion may be obtained. If the average refractive index is lower than 1.1, the porosity of the film is inevitably high, whereby no sufficient film strength may be obtained in some cases.

The refractive index of the optical functional film (e) may be uniform or may have distribution in the film, preferably within the above range of the average refractive index. In a case where it has distribution, the distribution is preferably such that the refractive index is gradually reduced from the non-light receiving surface toward the light receiving surface, whereby the reflectance can be suppressed to be low in a wide wavelength region.

Here, if the optical functional film (e) absorbs a light in a wavelength region in which the photoelectric conversion efficiency by the photoelectric conversion layer to be used is high (i.e. the effective wavelength region), specifically, a light in the above-mentioned effective wavelength region of each photoelectric conversion layer, the power generation efficiency of the photoelectric conversion layer is decreased, such being unfavorable. Further, if it absorbs a light in a wavelength region in which the photoelectric conversion efficiency is low (i.e. the ineffective wavelength region), the amount of light which reaches the wavelength conversion film is reduced, whereby no sufficient effect of improving the power generation efficiency of the photoelectric conversion layer by wavelength conversion may be obtained in some cases, such being unfavorable.

The average transmittance of the optical functional film (e) to a light in the effective wavelength region, specifically, a light in the above-mentioned effective wavelength region of each photoelectric conversion layer, and to a light in the ineffective wavelength region, specifically, a light in the above-mentioned ineffective wavelength region of each photoelectric conversion layer, is preferably from 90 to 100%, more preferably from 92 to 100%, further preferably from 93 to 100%.

The thickness of the optical functional film (e) is preferably set so that the average reflectance to a light in the effective wavelength region and to a light in the ineffective wavelength region is lowest, and is preferably from 80 to 1,000 nm, more preferably from 90 to 900 nm, further preferably from 100 to 800 nm.

The surface shape of the optical functional film (e) may be flat or may be a concave-convex shape. In a case where the refractive index is inclined by the concave-convex structure, reflection can be prevented in a wide wavelength region, such being favorable. The concave-convex structure is specifically preferably a diameter of from 20 to 1,000 nm, a depth of from 50 to 2,000 nm and a concave-convex pitch of from 20 to 1,000 nm. The concave shape may, for example, be a triangular pyramid, a quadrangular pyramid, a circular cone, a hemisphere, a parabola, an inverted parabola or a slit.

Further, as described above, the average reflectance at the interface on the light receiving surface side of the optical functional film (e) constituting the outermost layer on the light receiving surface side of the translucent laminated film to a light in the effective wavelength region of the photoelectric conversion layer to be used, specifically, to a light in the above-mentioned effective wavelength region of each photoelectric conversion layer, is preferably from 0 to 5%, more preferably from 0 to 3%, further preferably from 0 to 2%. Further, the average reflectance at the interface on the light receiving surface side of the optical functional film (e) to a light having a wavelength of from 300 to 400 nm is preferably at most 5%. Further, the average reflectance at the interface on the light receiving surface side of the optical functional film (e) to a light having a wavelength of from 400 to 1,200 nm is preferably at most 2%.

The constituents of the translucent laminated films according to the first to third embodiments of the present invention are described above. Now, materials constituting such constituents will be described below. With respect to the translucent substrate (a), the materials are as described above.

### <Material constitution for each layer>

The substrate front side wavelength conversion film (b) and the substrate rear side wavelength conversion films (d) and (d') contain a wavelength conversion material as the main component and may contain a matrix material to fix the wavelength conversion material to the other constituents of the translucent laminated film or to the photoelectric conversion layer. Further, they may be mixed with a low refractive index material and/or may be formed into porous structures, so that the refractive index is adjusted so as to be preferably within the above average refractive index range.

In the translucent substrate of the present invention, the substrate front side wavelength conversion film (b) and/or the substrate rear side wavelength conversion films (d) and (d') may be a single layer film containing a plurality of wavelength conversion materials described hereinafter, and containing a material which converts a light having a short wavelength at the light absorption long wavelength end by the light receiving surface side of the film into a light in the effective wavelength region. Otherwise, it may be a multilayer film comprising a plurality of wavelength conversion layers and having a layer with a short wavelength at the light absorption long wavelength end by the light receiving surface side of each film.

The antireflection film (c) contains a low refractive index material as the main component to adjust the refractive index preferably to be within the above average refractive index range, and may contain a matrix material to fix the low refractive index material to the other constituents of the translucent laminated film.

The optical functional film (e) contains a wavelength conversion material and a low refractive index material as the main components to adjust the refractive index to be preferably within the above average refractive index range, and may contain a matrix material to fix these materials to the other constituents of the translucent laminated film.

The antireflection film (c) and the optical functional film (e) may be formed into a porous structure, whereby the refractive index is adjusted to be preferably within the above average refractive index range.

### (1) Wavelength conversion material

The wavelength conversion material can be roughly classified into a material for up conversion and a material for down conversion.

As the down conversion material, a commonly used fluorescent or luminescent material may be employed, and an organic substance, an organic metal complex or an inorganic substance may be mentioned, and it may be used as a single substance or as mixed. It is not particularly limited so long as it is exited by a light in a wavelength region shorter than in the effective wavelength region, in which the photoelectric conversion efficiency is low (i.e. the ineffective short wavelength region) and which emits a light in a wavelength region in which the photoelectric conversion efficiency is high (i.e. the effective wavelength region), and for example, the following material may be exemplified. By quantum cutting, two photons having a long wavelength may be formed from one photon having a short wavelength, whereby there is a possibility that the quantum efficiency exceeds 100%, such being particularly favorable.

The organic substance may, for example, be indocyanine green, cumarin, xanthene, hematoporphyrin, fluorescamine, fluoranthene, perylene, eosin, acridine orange, rhodamine 123, rhodamine 6G, rhodamine B, fluorescein or a cyan dye.

The organic metal complex may be one having, as a central metal, a rare earth metal such as Sc, Y, La, Ce, Pr, Nd, Pm, Sm, Eu, Gd, Tb, Dy, Ho, Er, Tm, Yb or Lu, or Ir, and as a ligand, an organic ligand having a conjugated moiety analogous to an aromatic ring, bipyridine, terpyridine, phenanthroline, phthalocyanine, pyridine, quinoline, urotropine, β-diketone, dibenzoate, crown ether, cryptand, amine polycarboxylate, diphenyl, naphthalate, phthalate, pyrocatechol, pyrogallol, salicylate, 1-naphthoate, 2-naphthoate, 4-methyl-1-naphthoate, p-(t-butyl)benzoate, 3,3-dimethylbutanoate, alkylamine, aniline, imidazole, triazole, pyrimidine, pyrazine, aminopyridine, pyridine, adenine, thymine, guanine, cytosine or a derivative thereof.

It may, for example, be an Ir complex (such as Ir(bpy)₃, Ir(bpy)₃(PF₆)₃, Ir(tmphen)₃(PF₆)₃, Ir(bqn)₃(PF₆)₃, Ir(dpphen)₃(PF₆)₃, Ir(dmbpy)₃(PF₆)₃, Ir(dmdpphen)₃(PF₆)₃ or Ir(dpbpy)₃(PF₆)₃), a Ru complex (such as Ru(dpbpy)₃(PF₆)₂, Ru(dpphen)₃(PF₆)₂, Ru(dmdpphen)₃(PF₆)₂, Ru(tmphen)₃(PF₆)₂, Ru(dmbpy)₃(PF₆)₂, Ru(dmbpy)₃(ClO₄)₂, Ru(bqn)₃(PF₆)₂, Ru(bpy)₃(ClO₄)₂, Ru(bpy)₃(PF₆)₂ or Ru(dmdpphen)₃(ClO₄)₂), a Tb complex (such as TB(ACAC)₃, Tb(TFA)₃dpphen, Tb(TFA)₃phen, Tb(acac)₃dpphen, Tb(acac)₃phen, Tb(HFA)₃phen, Tb(FOD)₃phen, Tb(TFA)₃dmbpy, Tb(TFA)₃dpbpy or Tb(TFA)₃tmphen), an Eu complex (such as Eu(TFA)₃, Eu(FOD)₃phen, Eu(TFA)₃tmphen, Eu(TFA)₃phen, Eu(FOD)₃bpy, ATBTA-Eu₃ or DTBTA-Eu).

The inorganic substance may, for example, be Ag⁺, Ag⁻, (Ag,Cu)GaS₂, AlAs, AIN, Al₃Nd(BO₃)₄, Al₂O₃, Al₂O₃:Cr³⁺, AIP, AlSb, As³⁺, Au⁺, Au⁻, (Al,Ca)Ga₂S₄:(Ce³⁺,Sn²⁺), BAs, BP, BSb, BaAl₈O₁₃:Eu²⁺, BaAl₁₂O₁₉:Mn²⁺, BaB₂W₃O₁₈, (Ba,Ca,Mg)₅(PO₄)₃Cl:EU²⁺, (Ba,Ca,Mg)₁₀(PO₄)₆Cl:Eu²⁺, BaEr₂F₈, BaF₂, BaFBr:Eu²⁺, BaFCl:Eu²⁺, BaFCl:Sm²⁺, BaF₂:Sm²⁺, BaFl:Eu²⁺, BaFX:Eu²⁺, Ba₂(Gd,Eu)NbO₅, Ba₂La₂MgW₂O₁₂, BaMgAl₁₄O₂₃:Eu²⁺, BaMg₂Al₁₄O₂₄:Eu²⁺, BaMg₂Al₁₆O₂₇Eu²⁺, BaMg₂Al₁₆O₂₇:Eu²⁺,Mn²⁺, Ba₃MgSi₂O₈:Eu²⁺, (Ba,Mg,Zn)₃Si₂O₇:Pb²⁺, BaO, Ba₃(PO₄)₂:Eu²⁺, Ba₂P₂O₇:Ti⁴⁺, BaPt(CN)₄·4H₂O, BaS, BaSe, BaSi₂O₅:Pb²⁺, BaSO₄:Eu²⁺, BaSO₄:Pb²⁺, (Ba,Sr,Zn,Mg)₃Si₂O₇:Pb²⁺, Ba₃WO₃F₄, BaX₂:Eu²⁺, BaY₂F₈, Ba₂ZnS₃:Mn²⁺, BeO, Bi³⁺, Bi₄Ge₃O₁₂, (CH₃Co₂)₂Zn, CaF₂, CaF₂:(Eu²⁺,Mn²⁺,Sm²⁺), Ca₃La₂W₂O₁₂, CaMgAl₁₁O₁₉:Tb³⁺, (Ca,Mg)S:Mn²⁺, Ca₂MgSiO₇:Ce³⁺, (Ca,Mg)SiO₃:Ti, CaMg(SiO₃)₂:Ti, CaMoO₄, CaO, CaO:(Mn²⁺,Pb²⁺), 3Ca₃(PO₄)₂·Ca(F,Cl)₂:(Sb³⁺,Mn²⁺), Ca₃(PO₄)₂:(Ce³⁺,Mn²⁺), Ca₅(PO₄)₃(F,Cl):(Sb³⁺,Mn²⁺), Ca(PO₄)₃:(Tb³⁺,Nd³⁺,TI⁺), CaS, CaS:(Bi³⁺,Ce³⁺,Cl⁻,K⁺,Cu,Er³⁺,Eu²⁺,Mn²⁺,Sn²⁺), CaSO₄:(Dy³⁺,Mn²⁺,Tm³⁺,Sb,Sm³⁺, Tb³⁺), Ca₄Sb₄O₁₁F₁₂, CaSiO₃:(Pb²⁺,Mn²⁺), 3(Ca,Sr,Ba)₃(PO4)₂·(Ca,Sr,Ba)X₂:(Sb³⁺,Mn²⁺), (Ca,Sr)₃(PO₄)₂:Sn²⁺, (Ca,Sr)S:(Bi³⁺,Ce³⁺), Ca_{0.7}Sr_{0.3}S:(Bi³⁺,Cu), CaWO₄, CaWO₄:(Pb²⁺,W), (Ca,Zn)₃(PO₄)₂:(Sn²⁺,TI⁺), Cd, Cd₂B₂O₅:Mn²⁺, 3Cd₃(PO₄)₂·CdCl₂:Mn²⁺, Cd₅(PO₄)3Cl:Mn²⁺, CdS:(CI,Te), CdWO₄, Ce³⁺, CeMgA₁₁O₁₉:Tb³⁺, (Ce,Tb)MgAl₁₁O₁₉, Co²⁺, Cr³⁺, CsDyF₇:Dy⁴⁺, CsF, Csl:(Ag⁻,Na⁺,TI⁺), CS₂NaNdCl₆, Cs₃NdF₇:Nd⁴⁺, CsUO₂(Br,Cl)₄, Cu⁺, Cu²⁺, Cu⁻, CuS, Cu₂ZnSnS₄(Ce³⁺,Eu²⁺,Sn^{z+},Pb²⁺), Dy²⁺, Dy³⁺, Dy⁴⁺, DyF₃, Er³⁺, Eu²⁺, Eu³⁺, Eu₂O₃, Fe²⁺, Fe³⁺, Fe₂O₃, Ga⁺, GaAs, GaAs:Cr³⁺, GaN, GaP, GaP:(Bi,Cd,Mg, N,S,Si,Zn,O), GaSb, Gd³⁺, Ge²⁺, GeO₂, GdMgB₅O₁₀Ce³⁺,Tb³⁺, Gd₂(MoO₄)₃, Gd₂O₂S:(Pr³⁺,Ce³⁺,F⁻,Tb³⁺), Gd₂O₃:(Bi³⁺,Yb³⁺), GdTaO₄, (Gd,Y)₂O₂S:Tb³⁺, HfP₂O₇, Hf₃(PO₄)₄, Hg, HO²⁺, Ho³⁺, In⁺, InAs, InBO₃:(Eu³⁺,Tb³⁺), InBO₃:Tb³⁺, InN, In₂O₃, InP, InSb, KBr:(Ag⁻,Ga⁺,In⁺,TI⁺), KCl:(Ag⁻,Au⁻,Ga⁺,In⁺, Pb²⁺,Sn²⁺, TI⁺, (KF,MgF₂):Mn²⁺, KI:(Ag⁻,Ga⁺,In⁺,TI⁺), KLa(MoO₄)₂:Er³⁺, (K,Mg)F₃:Mn²⁺, K₂Pt(CN)₄Br₀.₃·3H₂O, K₂Pt(CN)₆:K₂Pt(CN)₄, La³⁺, La₂O₃·11Al₂O₃:Mn²⁺, LaOBr, LaOBr:(Tb³⁺,Tm³⁺), LaOCl:Tb³⁺, La₂O₂S:Tb³⁺, La₂O₃·0.2SiO₂·0.9P₂O₅:(Ce³⁺,Tb³⁺), LaPO₄:(Ce³⁺,Tb³⁺), LiAlO₂:Fe³⁺, Li₂B₄O₇, BiB₄O₇:Mn²⁺, LiF, Lil:Eu²⁺, LiMgPO₄:VO₄³⁻, LiNdP₄O₁₂, Li(Nd_{0.9}Yb_{0.1})P₄O₁₂, Li₂WO₆, LiZnVO₄, Ln₂O₂S:Tb³⁺, Ln₂(Pt(CN)₄)₃·nH₂O, Lu³⁺, LuPO₄:Yb³⁺, MgB₄O₇, MgF₂:Mn²⁺, Mg(Ga,Al)₂O₄:Mn²⁺, MgGa₂O₄:Mn²⁺, MgO, (MgO)x(As₂O₅)_{y}:Mn⁴⁺, 6MgO-As₂O₅:Mn⁴⁺, 2MgO·GeO₂:Mn⁴⁺, 3.5MgO·0.5MgF₂·GeO₂:Mn⁴⁺, MgS, MgS:Eu²⁺, Mg₂SiO₄, MgSiO₃:Mn²⁺, Mg₂SiO₄:Tb³⁺, Mg₃(VO₄)₂, MgWO₄, Mn²⁺, Mn⁴⁺, Mn⁷⁺, MnO₄, MoO₄²⁻, (NH₄)₂S, NaCaVO₄, NaCl, NaCl:(Ga⁺,In⁺), Na₅Eu(MoO₄)₄, Nal:TI⁺, Na(Lu,Eu)O₂, Na₅Nd(WO₄)₄, NaUO₂(CH₃COO)₃, NaWO₄, NaY₀.₆₉Y₀.₃₀Er₀.₀₁F₄, Nd³⁺, Nd⁴⁺, NdP₅O₁₄, Ni²⁺, Pb²⁺, PbMoO₄, PbWO₄, Pr³⁺, PrF₃, Pt(CN)₄²⁻, (Pt(II)(C₂H₅NH₂)₄)(Pt(IV)(C₂H₅NH₂)₄X₂)X₄·2H₂O(X=Cl,Br), Sb³⁺, Si, Si:(Ag,Ga,Cu,Al), Si₃N₄, SiO₂, Sm²⁺, Sm³⁺, Sn²⁺, SnO₂, SnO₂:Eu²⁺, Sr₄Al₁₄O₂₅:Eu²⁺, SrB₄O₇F:Eu²⁺, (Sr,Ba)Al₂Si₂O₈:Eu²⁺, (Sr,Ba,Mg)₃Si₂O₇:Pb²⁺, (Sr,Ca,Ba)₁₀(PO₄)₆Cl₂:Eu²⁺, (Sr,Ca)₁₀(PO₄)Cl₂-nB₂O₃:EU²⁺, (Sr,Ca)₁₀(PO₄)₆Cl₂:Eu²⁺, (Sr,Ca)₃(PO₄)₂:Sn²⁺, Sr₅Cl(PO₄)₃:Eu²⁺, SrFB₂O₃.₅:Eu²⁺, SrF₂:Sm²⁺, Sr_{0.96}Mg₀₋₈₁Al_{5.44}B_{0.44}B₁₀:Eu²⁺, SrMgAl₁₀O₁₇:EU²⁺, (Sr,Mg)₃(PO₄)₂:Cu²⁺, (SrMg)₂P₂O₇:EU²⁺, (Sr,Mg)₃(PO₄)₂:Sn²⁺, SrMg(SiO₄)₂:Eu²⁺, SrO, 2SrO·0.84P₂O₅·0.16B₂O₃:Eu²⁺, 3Sr₃(PO₄)₂·CaCl₂:Eu²⁺, Sr₅(PO₄)₃Cl:Eu²⁺, Sr₁₀(PO₄)₆Cl₂:EU²⁺, Sr₃(PO₄)₂:EU²⁺, Sr₅(PO₄)₃F:(Sb³+,Sn²⁺, Mn²⁺), 3Sr₃(PO₄)₂·SrCl₂:Eu²⁺, Sr₂P₂O₇:Eu²⁺, Sr₂P₂O₇:(Eu²⁺,Sn²⁺), 3Sr₃(PO₄)₂·SrF₂:(Sn²⁺,Mn²⁺), Sr₃(PO₄)₂:Yb²⁺, SrS, SrS:(Ce³⁺,Cl⁻,K⁺,Sm³⁺,Cu,Na,Eu²⁺,Mn²⁺), SrSe, Sr₄Si₃O₈Cl₄:Eu²⁺, Sr₂Si₃O₈·2H₂OSrCl₂:Eu²⁺, (Sr,Zn)₃(PO₄)₂:Sn²⁺, Tb³⁺, TbF₃, TbₓLa₁₋ₓP₅O₁₄, Ti³⁺, TiO₂, TI⁺, TICl:Be,I, Tm²⁺, Tm³⁺, UO₂²⁺, (UO₂Cl₄)²⁻, V³⁺, VO₄³⁻, WO₄²⁻, WO₆⁶⁻, Y³⁺, Y₃(Al,Ga)₅O₁₂:(Tb³⁺,Ce³⁺), YAl₃(BO)₃:(Tb³⁺Yb³⁺), Y₃Al₃Ga₂O₁₂:(Tb³⁺,Ce³⁺), YAlO₃:Ce³⁺, Y₃Al₅O₁₂:(Ce³⁺,Nd³⁺,Tb³⁺), Y₃Al₅O₁₂, Y₄Al₂O₉, YAlO₃, YAlO₃:(Er³⁺,Eu³⁺,Ho³⁺,Nd³⁺,Tₘ³⁺), YBO₃:Eu³⁺, Y_{0.8}Er_{0.2}F₃, YF₃, YF₃:(Eu³⁺,Pr³⁺), Y_{0.65}Gd_{0.35}BO₃:Eu³⁺, (Y,Gd)₂O₂S:Tb³⁺, Y(P,V)O₄:Eu²⁺, Y₂O₃, Y₂O₃·Al₂O₃:Tb³⁺, Y₂O₃·nAl₂O₃:Tb³⁺, Y₂O₃:(Eu³⁺,Bi³⁺), Y₂O₂S:(Eu³⁺,Tb³⁺,Sm³⁺,Yb³⁺,Bi³⁺), YPO₄:(Ce³⁺Tb³⁺,VO₄³⁻,Bi³⁺), YP_{0.65}V_{0.35}O₄:Eu³⁺, (Y₁₋ₓ Prₓ)₂O₂S, Y₂SiO₅:(Ce³⁺,Tb³⁺), YTaO₄, Y(V,P)O₄:Eu³⁺, YVO₄, YVO₄(Dy³⁺,Er³⁺,Eu³⁺,Ho³⁺,Sm³⁺,Tb³⁺,Tm³⁺), Y_{0.84}Yb_{0.15}Er₀.₀₁F₃, Y_{0.74}Yb_{0.25}Er_{0.01}OCl, Y_{0.65}Yb_{0.35}Tm_{0.001}F₃, Yb²⁺, Yb³⁺, Zn, (Zn,Be)₂SiO₄:Mn²⁺, (Zn,Cd,Mg)Silicate:Mn²⁺, (Zn,Cd)S, (Zn,Cd)S:(Ag,Au,Al,Cl,Ni,Cu,Ga), (Zn,Mg)F₂:Mn²⁺, (Zn_{1/2},Mg_{1/2})₃(PO₄)₂:Mn²⁺, Zn₃(Mg)(PO₄)₂:Mn²⁺, ZnO, ZnO:(Cu,Zn,Eu³⁺), Zn(OH)₂, Zn₃(PO₄)₂:Mn²⁺, ZnS, ZnS:(Ag,Al,Cl,Cu,Ga,In,Ni,Mn,I,DyF₃,ErF₃,Er³⁺,Na⁺,Fe²⁺,Fe³⁺,LnF₃,Nd³⁺,Li⁺,Pb,Cu,PrF₃ ,SmF₃,Sm³⁺,Tb³⁺,TbF₃,Tm³⁺,TmF₃,Zn), Zn(S,Se), Zn(S,Se):(Ag,Cl), ZnSe, ZnSe:Mn²⁺, ZnSiO₄:(Mn²⁺,As,Ti), ZnTe, ZnTe:O, ZnWO₄, ZnS:Ag, ZnS:Ag,Al, ZnS:Ag,Cu,Ga,Cl, ZnS:Al⁺ln₂O₃, ZnS:Zn⁺In₂O₃, (Ba,Eu)MgAl₁₀O₁₇, (Sr,Ca,Ba,Mg)₁₀(PO₄)₆Cl₁₇:Eu, Sr₁₀(PO₄)₆Cl₁₂:Eu, (Ba,Sr,Eu)(Mg,Mn)Al₁₀O₁₇, (Mg,Zn)Ga₂O₄:Mn, 10(Sr,Ca,Ba,Eu)·6PO₄·Cl₂, BaMg₂Al₁₆O₂₅:Eu, ZnS:Cl,Al, (Zn,Cd)S:Cu,Al, Y₃Al₅O₁₂:Tb, Y₃(Al,Ga)₅O₁₂:Tb, Y₂SiO₅:Tb, Zn₂SiO₄:Mn, ZnS:Cu⁺Zn₂SiO₄:Mn, Gd₂O₂S:Tb, (Zn,Cd)S:Ag, Y₂O₂S:Tb, ZnS:Cu,Al⁺In₂O₃, (Zn,Cd)S:Ag⁺In₂O₃, (Zn,Mn)₂SiO₄, BaAl₁₂O₁₉:Mn, (Ba,Sr,Mg)O·aAl₂O₃:Mn, LaPO₄:Ce,Tb, 3(Ba,Mg,Eu,Mn)O·8A₂O₃, La₂O₃-O.2SiO₂·O.9P₂O₅:Ce,Tb, CeMgAl₁₁O₁₉:Tb, (Y,La)₂O₂S:(Eu,Sm), Y₂O₃:Eu, Zn₃(PO₄)₂:Mn, (Zn,Cd)S:Ag⁺ln₂O₃, (Y,Gd, Eu)BO₃, (Y,Gd, Eu)₂O₃, (Y,La,Gd,Ln)(PO₄,VO₄):(Sm,Eu,Dy,Bi), or YAG:(Ce³⁺,Yb³⁺).

The above description of compounds with brackets, i.e. the description such as (A,B), (A,B,C) or (A,B,C,D) (wherein each of A,B,C,D is an element) means that the elements in the brackets can be used alone or as mixed. Further, the description of E:F (wherein E is a compound and F is an element) for the above compounds means a compound of E doped with F. The same applies in the following specification.

Further, as the inorganic substance, in addition to the above material, semiconductor nanoparticles may also be used, and particularly semiconductor nanoparticles having an average primer particle size of at most 20 nm are preferred. The semiconductor nanoparticles having an average primary particle size of at most 20 nm emit light in various regions from red (long wavelength) to blue (short wavelength) by changing the size of the nanoparticles, and the excitation wavelength is not limited so long as the energy is higher than the band gap. Further, the semiconductor nanoparticles, which have an emission life shorter by 100,000 times than a rare earth, quickly undergo repetition of absorption and light emission cycles, whereby they can realize an extremely high brightness, and are less likely to be deteriorated than an organic substance. For example, the number of photons emitted as fluorescence until the semiconductor nanoparticles are deteriorated is considered to be about 100,000 times of a dye, whereby an extremely high brightness can be realized.

The average primary particle size in this specification means an average of primary particle sizes of 100 particles measured by a transmission electron microscope.

The semiconductor nanoparticles may, for example, be a compound of a single element of group 14 in the Periodic Table (such as C, Si, Ge or Sn), a compound of a single element of group 15 in the Periodic Table (such as P), a compound of a single element of group 16 in the Periodic Table (such as Se or Te), a compound of an element of group 14 in the Periodic Table (such as SiC), a compound of an element of group 13 in the Periodic Table and an element of group 15 in the Periodic Table (such as BN, AIN, AIP, AlAs, AISb, GaN, GaP, GaAs, GaSb, InN, InP, InAs or InSb) or a ternary compound or a quaternary compound (such as Gaₓln₁₋ₓPyAs_{1-y} (x = 0 to 1, y = 0 to 1)), a compound of an element of group 15 in the Periodic Table and an element of group 16 in the Periodic Table (such as As2S3, As₄S₄, As₂Se₃, As₂Te₃, Sb₂S₃, Sb₂Se₃, Sb₂Te₃, Bi₂S₃, Bi₂Se₃ or Bi₂Te₃) or a ternary compound or a quaternary compound (such as AsₓSb₁₋ₓS_{y}Se_{1-y} (x = 0 to 1, y = 0 to 1)), a compound of an element of group 14 in the Periodic Table and an element of group 16 in the Periodic Table (such as SiO₂, GeS, GeSe, GeTe, SnO₂, SnS, SnSe, SnTe, PbO₂, PbS, PbSe or PbTe) or a ternary compound or a quaternary compound (such as GeₓSn₁₋ₓS_{y}Se_{1-y} (x = 0 to 1, y = 0 to 1)), a compound of an element of group 13 in the Periodic Table and an element of group 16 in the Periodic Table (such as Al₂O₃, Ga₂O₃, GaS, GaSe, GaTe, In₂O₃, InS, InSe, InTe, TIS, TISe or TITe) or a ternary compound or a quaternary compound (such as GaₓIn₁₋ₓS_{y}Se_{1-y} (x =0 to 1, y = 0 to 1)), a compound of an element of group 12 in the Periodic Table and an element of group 16 in the Periodic Table (ZnO, ZnS, ZnSe, ZnTe, CdO, CdS, CdSe, CdTe, HgS, HgSe or HgTe) or a ternary compound or a quaternary compound (such as ZnₓCd₁₋ₓSySe_{1-y} (x = 0 to 1, y = 0 to 1)), a compound of an element of group 11 in the Periodic Table and an element of group 16 in the Periodic Table (such as CuO, Cu₂O, Ag₂S or CuSe), a compound of an element of group 10 in the Periodic Table and an element of group 16 in the Periodic Table (NiS₂, PdS or PtSe), a compound of an element of group 9 in the Periodic Table and an element of group 16 in the Periodic Table (such as CoSe, RhS or IrSe), a compound of an element of group 8 in the Periodic Table and an element of group 16 in the Periodic Table (such as FeO, FeS, FeSe or Rus), a compound of an element of group 7 in the Periodic Table and an element of group 16 in the Periodic Table (such as MnO, MnS, MnSe or ReS), a compound of an element of group 6 in the Periodic Table and an element of group 16 in the Periodic Table (such as Cr₂S₃, Cr₂Se₃ or MoS₂), a compound of an element of group 5 in the Periodic Table and an element of group 16 in the Periodic Table (such as V₂O₅, VS, VSe, NbS), a compound of an element of group 4 in the Periodic Table and an element of group 16 in the Periodic Table (such as TiO₂, TiS₂, ZrO₂ or ZrS₂), a compound of an element of group 2 in the Periodic Table and an element of group 16 in the Periodic Table (such as MgO, CaO, SrO, MgS or CaS), a compound of an element of group 11 in the Periodic Table, an element of group 13 in the Periodic Table and an element of group 16 in the Periodic Table (CuAlO₂, CuGaO₂, CuInO₂, CuAlS₂, CuGaS₂, CuInS₂, CuAlSe₂, CuGaSe₂, CuInSe₂, AgAlO₂, AgGaO₂, AgInO₂, AgAlS₂, AgGaS₂, AgInS₂, AgAlSe₂, AgGaSe₂, AgInSe₂) or a quaternary compound (such as AgCuInSe₂), a quinary compound (such as AgCuInSSe) or a senary compound (such as AgCulnGaSSe), a compound of an element of group 12 in the Periodic Table, and element of group 14 in the Periodic Table and an element of group 15 in the Periodic Table (such as ZnSnN₂, ZnPbN₂, ZnSnP₂, ZnPbP₂, ZnSnAs₂, ZnPbAs₂, ZnSnSb₂ or ZnPbSb₂) or a quaternary compound (such as CdZnSnP₂), a quinary compound (such as CdZnSnPbP₂) or a senary compound (such as CdZnSnPbPAs), a compound of an element of group 13 in the Periodic Table and an element of group 17 in the Periodic Table (such as TICl, TIBr or TII), or a compound of an element of group 11 in the Periodic Table and an element of group 17 in the Periodic Table (such as CuCl, AgBr or AuCl).

The up conversion material is a material which emits a light having a wavelength shorter than the absorption wavelength, by light emission from the upper level from an electronic state where a plurality of photons are simultaneously or sequentially absorbed by means of multistep excitation. It may, for example, be rare earth-doped crystals or glass, and it may be used as a single substance or as mixed. It is not particularly limited so long as it is a material which is excited by a light in a wavelength region lower than the effective wavelength region in which the photoelectric conversion efficiency is low (i.e. the ineffective long wavelength region) and which emits a light in a wavelength region in which the photoelectric conversion efficiency is high (i.e. the effective wavelength region) and for example, the following materials may be exemplified.

LiKYF₅:Pr³⁺, Bi₄Ge₃O₁₂:Pr³⁺, Y₂O₃:Pr³⁺, LiYF₄:Pr³⁺, KYb(WO₄)₂:Pr³⁺, PbWO₄:Pr³⁺, 60GeO₂-25PbO-15Nb₂O₅:Pr³⁺, GeS₂-25Ga₂S₃-25CsX(X=Cl,Br):Pr³⁺, Bi₄Ge₃O₁₂:Nd³⁺, K₅Nd(WO₄)_{4:}Nd³⁺, Pb₅Al₃F₁₉:Nd³⁺, LiYF₄:Nd³⁺, CaF₂-YF₃:Nd³⁺, 6060GeO₂-25PbO-15Nb₂O₅:Nd³⁺, 25CdF₂-13.5CdCl₂-30NaF-20BaF₂-1.5BaCl₂:Nd³⁺, YAlO₃:(Ho³⁺,Yb³⁺), KYb(WO₄)₂:Ho³⁺, LiTaO₃:Ho³⁺, YVO₄:(Ho³⁺Yb³⁺), Y₂O₃:(HO³⁺,Yb³⁺), Lu₃Al₅O₁₂:HO³⁺, BaY₂F₈:HO³⁺, LiYF₄:Ho³⁺, YAlO₃:Er³⁺, SrLaAlO₄:Er³⁺, Ca₃Al₂Ge₃O₁₂:Er³⁺, YVO₄:Er³⁺, YSZ:Er³⁺, CaGdAlO₄:Er³⁺, Ca₃Ga₂Ge₄O₁₄:Er³⁺, YAG:Er³⁺, LiNbO₃:Er³⁺, Y₂O₃:(Er³⁺,Yb³⁺), Lu₂O₃:(Er³⁺,Yb³⁺), Gd₃Ga₅O₁₂:Er³⁺, ZrO₂:Er³⁺, LiNbO₃:Er³⁺, La₂O₃:(Er³⁺,Yb³⁺), Gd₂O₃:(Er³⁺,Yb³⁺), NaYF₄:(Er³⁺,Yb³⁺), LaF₃:(Er³⁺,Yb³⁺), Y₃Sc₂Ga₃O₁₂:(Tm³⁺,Yb³⁺), Gd₃Ga₅O₁₂:(Tm³⁺,Yb³⁺), GdAlO₃:(Tm³⁺,Yb³⁺), Y₂O₃:(Tm³⁺,Yb³⁺), KY(WO₄)_{2:}(Tm³⁺,Yb³⁺), NaYF₄:(Tm³⁺,Yb³⁺), ZᵣO₂:(Tm³⁺,Yb³⁺), and Gd₂(MoO₄)₃:(Tm³⁺,Yb³⁺) may, for example, be mentioned.

The wavelength conversion material to be used for the optical functional film (e) is preferably one having excellent weather resistance, more preferably an inorganic material, since the optical functional film (e) constitutes the outermost layer on the light receiving surface side of the translucent laminated film and is usually used in an environment exposed to the air environment. The wavelength conversion material to be used for the substrate front side wavelength conversion film and the substrate rear side wavelength conversion film may be a material having low weather resistance, since such a material is provided between the antireflection film (c) or the optical functional film (e) constituting the outermost layer on the light receiving surface side of the translucent laminated film and the photoelectric conversion layer and is protected.

The form of the wavelength conversion material is not particularly limited, and it may, for example, be a matrix form, a particle form or a film form, and is preferably a nanoparticle form in view of transparency and excellent fluorescent properties. The average primary particle size of the particles is preferably within a range of from 0.5 to 300 nm with a view to securing the transparency, more preferably from 1 to 200 nm, further preferably from 2 to 100 nm. The shape of the particles may be spheres, horns, needles, sheets, chains, fibers or hollow particles. The wavelength conversion material to be used for the optical functional film (e) is particularly preferably in the form of hollow particles in view of the refractive index.

In a case where the wavelength conversion material is in the form of nanoparticles, the physical properties of the particles can be changed by forming the nanoparticles to have a core-shell structure. The shell preferably comprises a metal, a semiconductor or an insulating material, and the above-described composition may be applicable. An effect of protecting the core particles by the shell can also be expected, and when it is applied to semiconductor quantum dots, it is possible to improve the light emission properties by forming terminals of dangling-bonds and/or quantum well structure. When the lattice matching property between the core material and the shell material is high, epitaxial growth from the core particle surface is possible, whereby the lattice distortion is less likely to occur, such being favorable.

In a case where the energy in the conduction band of the shell material is higher than that of the core material and the energy in the valence band is lower than that of the core material, the exciton formed in the interior of the core will not spread over the entire particle and the recombination will occur while it is trapped in the interior of the core, whereby it is possible to improve the light emission intensity. A core-multishell structure obtainable by forming on a core with a broad band gap a shell with a band gap narrower than that, and forming another shell with a broad band gap, is preferred, since the exciton is completely trapped in the shell with a narrow band gap, and the physical properties can be controlled by the thickness of the shell.

The material of the shell may be selected from the above wavelength conversion materials, or other than them, an organic resin, a metal, a metal oxide, a metal nitride, a metal sulfide, a metal selenide or the like may be used. In view of the adhesion to other constituents constituting the translucent laminated film or to the photoelectric conversion layer, a metal oxide is preferred, and SiO₂ is more preferred.

### (2) Low refractive index material

The low refractive index material to be used for the antireflection film (c) and the optical functional film (e) and as the case requires, the substrate front side wavelength conversion film (b) and the substrate rear side wavelength conversion films (d) and (d'), has a refractive index to a light having a wavelength of from 300 to 1,000 nm of preferably from 1.05 to 1.4, more preferably from 1.1 to 1.35, further preferably from 1.15 to 1.3. It is preferably one having excellent weather resistance, more preferably an inorganic material, since the antireflection film (c) and the optical functional film (e) are formed on the outermost surface on the light receiving surface side of the translucent laminated film and are usually used in an environment exposed to the air environment. The inorganic material may, for example, be a fluoride such as MgF, a metal oxide, a metal nitride, a metal sulfide or a metal selenide, and is preferably a metal oxide in view of the weather resistance, and is more preferably SiO₂ in view of the adhesion to other constituents constituting the translucent laminated film or to the photoelectric conversion layer and the refractive index.

In order to lower the average refractive index of the antireflection film (c) and the optical functional film (e) to a light having a wavelength of from 300 to 1,000 nm in the film thickness direction, it is preferred that a gas component such as air is contained, that is, the film is porous, and the pore volume ratio is preferably from 1 to 90%, more preferably from 5 to 80%, further preferably from 10 to 70%. The pores may be open cells or may be closed cells, but are preferably closed cells in view of the durability. Further, as the case requires, the substrate front side wavelength conversion film (b) and the substrate rear side wavelength conversion films (d) and (d') may also have a porous film structure so as to reduce the average refractive index. In such a case, the pore volume ratio is preferably from 1 to 80%, more preferably from 5 to 70%, further preferably from 10 to 60%.

Further, the pores may have regularity in a certain direction relative to the film thickness direction, and a structure in which honeycomb pores are arranged at right angles to the film thickness direction (i.e. vertically aligned mesoporous silica) may, for example, be mentioned. The diameter of each pore is preferably smaller than the wavelength of the received light so as to prevent scattering, and is preferably from 1 to 300 nm, more preferably from 2 to 200 nm, further preferably from 3 to 100 nm. The distribution of the pore diameter is preferably narrower in view of the film strength, as the stress to the antireflection film (c), the optical functional film (e) or the like tends to be uniform.

To form the pores, a method of using a hollow compound having pores preliminarily formed in its interior, and/or a method of mixing a material capable of being removed by a physical means such as heat, an acid, light irradiation or drying treatment and/or a chemical means, and a material incapable of being removed, and then selectively removing only the material capable of being removed, may be mentioned. A pore-forming material may, for example, be a heat decomposable substance (such as surfactant micelles, a water-soluble organic polymer, a styrene resin, an acrylic resin, a block copolymer, carbon, terpene or polyethylene glycol), an acid-soluble substance (such as ZnO, NaAlO₂, CaCO₃ or basic ZnCO₃), a photo-soluble substance (such as ZnS, ZnSe or ZnO) or a reaction-soluble substance (such as Au or Ag).

A hollow compound is obtainable by covering particles of the above pore-forming material with a material incapable of being removed, and selectively removing only the material capable of being removed. The form of the material incapable of being removed may be a form of particles or a form of a matrix, and two or more types may be mixed. Further, the optical functional film (e) contains a wavelength conversion material having a wavelength conversion function and preferably contains hollow particles having an average refractive index within a range of from 1.1 to 1.8.

The optical functional film (e) is preferably formed by mixing the above pore-forming material and the wavelength conversion material to form a coating film, and selectively removing only the pore-forming material, or by mixing the hollow compound and the wavelength conversion material to form a coating film.

### (3) Matrix material

The matrix material is a material which can be used as mixed with the above wavelength conversion material and/or antireflection material, and which increases the adhesion to other constituents constituting the translucent laminated film or to the photoelectric conversion layer. If the matrix material absorbs a light in the ineffective wavelength region which reaches the wavelength conversion material or a light in the effective wavelength region which reaches the photoelectric conversion layer, the effects of the present invention tend to be decreased, such being unfavorable. Accordingly, it is preferably transparent to a light in the ineffective wavelength region, specifically, a light in the above-mentioned ineffective wavelength region of each photoelectric conversion layer, and a light in the effective wavelength region, specifically, a light in the above-mentioned effective wavelength region of each photoelectric conversion layer, and has an average transmittance to a light having such a wavelength of preferably from 80 to 100%, more preferably from 85 to 100%, further preferably from 90 to 100%.

By mixing the matrix material and the wavelength conversion material, not only the adhesion to the translucent substrate can be increased, but also the refractive index of the wavelength conversion layer can be made low, such being favorable. The addition amount of the matrix is preferably from 1 to 50 mass% of the total solid content, more preferably from 2 to 45%, further preferably from 3 to 40%. If it is less than 1%, no sufficient adhesion to the substrate may be obtained, such being unfavorable. If it exceeds 50 mass%, the thickness required to obtain a sufficient wavelength conversion effect tends to be thick, thus leading to cracking, such being unfavorable.

Further, if the refractive index is high, the antireflection function tends to be low, and accordingly the refractive index to a light having a wavelength of from 300 to 1,000 nm is preferably from 1.2 to 1.7, more preferably from 1.25 to 1.6, further preferably from 1.3 to 1.5. The matrix material may be either an inorganic substance or an organic substance. The organic substance may, for example, be an epoxy resin, a silicone resin, a fluororesin, a polystyrene resin, an aromatic polycarbonate resin such as bisphenol A polycarbonate, an acrylic resin such as polymethyl methacrylate, an amorphous polyolefin resin, an epoxy resin, a silicone resin, polyethylene terephthalate, polybutylene terephthalate, polyethylene naphthalate, polystyrene, polycarbonate, polyether sulfone, cellulose acetate, polyarylate or an ethylene/vinyl acetate copolymer resin.

The inorganic substance may, for example, be a metal oxide, a metal nitride, a metal sulfide or a metal selenide. It is preferably a metal oxide in view of the adhesion to other constituents constituting the translucent laminated film or to the photoelectric conversion layer, more preferably SiO₂. SiO₂ may be obtainable by hydrolyzing an alkoxysilane or the like, and the alkoxysilane may, for example, be tetraalkoxysilane (such as tetramethoxysilane, tetraethoxysilane, tetrapropoxysilane or tetrabutoxysilane), an alkoxysilane having a perfluoropolyether group (such as perfluoropolyether triethoxysilane), an alkoxysilane having a perfluoroalkyl group (such as perfluoroethyltriethoxysilane), an alkoxysilane having a vinyl group (such as vinyltrimethoxysilane or vinyltriethoxysilane), an alkoxysilane having an epoxy group (such as 2-(3,4-epoxycyclohexyl)ethyltrimethoxysilane, 3-glycidoxypropyltrimethoxysilane, 3-glycidoxypropylmethyldiethoxysilane or 3-glycidoxypropyltriethoxysilane), or an alkoxysilane having an acryloyloxy group (such as 3-acryloyloxypropyltrimethoxysilane).

The matrix material to be used for the antireflection film (c) and the optical functional film (e) preferably has high durability, and is more preferably an inorganic material, since these films constitute an outermost layer on the light receiving surface side of the translucent laminated film and are usually used in an environment exposed to the air environment. On the other hand, the matrix material to be used for the substrate front side wavelength conversion film (b) and the substrate rear side wavelength conversion films (d) and (d') may be a material having low weather resistance, since such layers are provided between the antireflection film (c) or the optical functional film (e) constituting the outermost layer on the light receiving surface side of the translucent laminated film and the photoelectric conversion layer and are protected.

### <Film forming process for the respective constituents in translucent laminated film>

Now, a film forming process of forming the respective constituents in the translucent laminated film of the present invention using the above materials will be described.

The film forming process may be a process of applying film forming compositions for the respective constituents constituting the translucent laminated film of the present invention i.e. the substrate front side wavelength conversion film (b), the substrate rear side wavelength conversion film (d) or (d'), the antireflection film (c) and the optical functional film (e), obtained by adjusting/blending the above-described materials or precursor materials in conformity with the functions of the respective films, on a substrate (surface to be coated) on which the respective films are to be formed by a known coating method, followed by heat treatment as the case requires. The order of lamination of the respective films is as described for the translucent laminated films according to the first to third embodiments of the present invention.

The coating method may be a known wet coating method (such as roller coating, flexographic coating, bar coating, die coating, gravure coating, roll coating, flow coating, spray coating, ultrasonic spray coating, an ink jet method, dip coating, spin coating, curtain coating, screen coating, nanoimprinting or roll transfer coating).

The coating temperature is preferably from room temperature to 80°C, more preferably from room temperature to 60°C. Online spray coating may also be applicable, which is a method of spray coating on the line on which the substrate to be coated is formed as it is, and an article can be produced at a low cost since a step of re-heating the substrate after coating is omitted, such being useful. The coating temperature in the online spray coating is preferably from 100 to 800°C, more preferably from 200 to 700°C. As a specific example of the online coating, in a continuous glass plate production line of melting glass materials, forming the obtained molten glass into a glass ribbon, annealing the glass ribbon while it is transferred, and then cutting the glass ribbon to produce a glass plate, the film forming composition is applied to the glass ribbon surface by spray coating to form a film, at a position with a desired temperature of the glass ribbon being transferred (for example, a position before the glass ribbon enters an annealing furnace to anneal the glass ribbon or a position after it exits from the annealing furnace).

Further, as a film forming process for the substrate front side wavelength conversion film (b), the substrate rear side wavelength conversion film (d) or (d'), the antireflection film (c) and the optical functional film (e), desired film forming materials for the respective films are selected and applied by a known dry coating method (such as vacuum deposition, sputtering, RF sputtering, CVD, microwave plasma CVD, MOCVD, PLD, ion beam deposition or aerosol deposition).

By carrying out a heat treatment after film forming compositions containing materials or precursor materials to form films, the adhesion between the layers can be increased. Heating may be conducted by means of hot air, an electric furnace, superheated steam or microwave irradiation. In a case where the substrate is made of glass, by introducing a sample after film forming into a glass heat tempering furnace, the adhesion between the layers can be increased simultaneously with glass tempering, such being favorable. The heat treatment temperature is preferably from 80 to 800°C, and in the case of glass, it is more preferably from 500 to 700°C.

### (Solvent, additive)

In a case where a wet coating method is employed for the film forming process, the film forming composition may contain the following solvent or additive.

The solvent may, for example, be water, an alcohol (such as methanol, ethanol, isopropanol, butanol or diacetone alcohol), a ketone (such as acetone, methyl ethyl ketone or methyl isobutyl ketone), an ether (such as tetrahydrofuran or 1,4-dioxane), a cellosolve (such as methyl cellosolve or ethyl cellosolve), an ester (such as methyl acetate or ethyl acetate), a glycol ether (such as ethylene glycol monoalkyl ether), a nitrogen-containing compound (such as N,N-dimethylacetamide, N,N-dimethyl sulfoxide or N-methylpyrrolidone), or a sulfur-containing compound (such as dimethyl sulfoxide).

The additive which may optionally be blended in the film forming composition may, for example, be a surfactant to improve the leveling property, or a metal chelate compound to improve the durability of the coating film. The surfactant may, for example, be silicone oil.

The metal chelate compound may, for example, be an aluminum chelate compound (such as aluminum acetylacetonate, aluminum bisethylacetoacetate monoacetylacetonate, aluminum-di-n-butoxide-monoethylacetoacetate, aluminum-di-isopropoxide-monomethylacetoacetate or diisopropoxyaluminum ethylacetate), a zirconium chelate compound (such as zirconium tetraacetylacetonate or zirconium tributoxystearate), a titanium chelate compound (such as titanium acetylacetonate or titanium tetraacetylacetonate), a copper chelate compound (such as copper acetylacetonate), a cerium chelate compound (such as cerium acetylacetonate), a chromium chelate compound (such as chromium acetylacetonate), a cobalt chelate compound (such as cobalt acetylacetonate), a tin chelate compound (such as tin acetylacetonate), an iron chelate compound (such as iron(III) acetylacetonate), a manganese chelate compound (such as manganese acetylacetonate), a nickel chelate compound (such as nickel acetylacetonate) or a zinc chelate compound (such as zinc acetylacetonate).

### <Other functional layer>

On the translucent laminated films according to the first to third embodiments of the present invention, various functional layers, for example, an adhesion improving layer or a protective layer may be formed within a range not to impair the effects of the present invention, in addition to the essential or optional constituents constituting each laminated film, as mentioned above. In the present invention, in view of the productivity and the durability, the laminated film is formed only by the essential constituents according to each embodiment of the present invention as mentioned above, or only by the essential constituents and the substrate rear side wavelength conversion film with respect to the translucent laminated film according to the first or third embodiment.

Between the layers from the outermost layer on the light receiving surface of the translucent laminated film to the light receiving surface side of the photoelectric conversion layer, or outside the outermost layer, a functional layer having one or more functions selected from hard coating, alkali barrier, coloring, electrical conductivity, antistatic effect, light scattering, antireflection, light condensation, light polarization, ultraviolet shielding, infrared shielding, anti-fouling, antifogging, photocatalyst, antibacterial property, fluorescence, luminescence, refractive index control, water repellency, oil repellency, finger print removal, lubricity and the like imparted, formed by film formation using a material made of an inorganic substance and/or an organic substance and/or by having such a material incorporated in its interior, may be provided.

### <Photoelectric conversion layer>

Each of the translucent laminated films according to the first to third embodiments of the present invention is used as provided on the light receiving surface side of the photoelectric conversion layer. The translucent laminated film of the present invention has light transparency and the respective functions of the antireflection function and the wavelength conversion function, and by these functions, it can make a light in a wavelength region in which the photoelectric conversion efficiency by the above photoelectric conversion layer is high among the received light, efficiently reach the photoelectric conversion layer, and in addition, it can function also as a protective layer to increase the durability of the photoelectric conversion layer such as the weather resistance and the mechanical strength.

The photoelectric conversion layer for which the translucent laminated film of the present invention functions as above, may, for example, be a solar cell. The solar cell may, for example, be specifically a single crystal silicon solar cell, a polycrystalline silicon solar cell, a microcrystalline silicon solar cell, an amorphous silicon solar cell, a GaAs compound type solar cell, a CIS compound type solar cell, a CIGS compound type solar cell, a CZTS compound type solar cell, a CdTe compound type solar cell, a dye-sensitized solar cell, an organic thin-film solar cell, a hybrid solar cell, a thin-membrane silicon solar cell, a spherical silicon solar cell, a tandem solar cell, a multi-junction solar cell or a quantum dot solar cell.

Further, the up-conversion among wavelength conversion requires a very high light energy, and accordingly when the translucent laminated film of the present invention has an up-conversion function, it is preferably used in combination with a condensing apparatus to adjust the received light.

Further, according to the present invention, by using the translucent laminated film as a protective cover on the light receiving surface side of a solar cell, a solar cell module with a good photoelectric conversion efficiency can be provided. Further, the same effects will be obtained when the translucent laminated film of the present invention is applied to a reflector for a solar cell.

### EXAMPLES

Now, the present invention will be described in further detail with reference to Examples. However, it should be understood that the present invention is by no means restricted to such specific Examples.

Examples 1 to 8 are Examples of the present invention, and Examples 9 to 11 are Comparative Examples. Physical property evaluation items and measurement/evaluation methods for materials used, the obtained films and translucent laminated films in Examples of the present invention and Comparative Examples, are shown below. Hereinafter, the term for the coating film of "a translucent substrate provided with a coating film" generically means an antireflection film, an optical functional film and a wavelength conversion film.

### (1) Average primary particle size

As the average primary particle size of fine particles, 100 particles were randomly selected by using a transmission electron microscope (manufactured by Hitachi, Ltd., H-9000), the particle sizes of the respective fine particles were measured, and the particle sizes of the 100 fine particles were averaged to determine the average primary particle size of a wavelength conversion material and an antireflection material.

### (2) Film thickness

The torn surface of a translucent substrate provided with a coating film was observed by a scanning electron microscope (manufactured by Hitachi, Ltd., S4300) to measure the film thickness.

### (3) Film refractive index

A translucent substrate provided with a coating film was measured by an ellipsometer (manufactured by J. A. Woollam, model: M-2000DI) to determine the average refractive index at a wavelength of from 300 to 1,000 nm.

### (4) Average reflectance

The reflectance of a translucent substrate provided with a coating film in the effective wavelength region (from 350 to 750 nm in the case of a-Si, and from 400 to 1,100 nm in the case of c-Si) was measured by a spectrophotometer (manufactured by Hitachi, Ltd., model: U-4100) to determine the average reflectance.

### (5) Average transmittance

The transmittance of a translucent substrate provided with a coating film in the effective wavelength region (a-Si: from 350 to 750 nm, c-Si: from 400 to 1,100 nm) was measured by a spectrophotometer (manufactured by Hitachi, Ltd., model: U-4100) to determine the average transmittance. In a case where figured glass was used as the translucent substrate, the figured surface was coated with anisole (manufactured by KANTO CHEMICAL CO., INC.) and quartz glass was bonded thereto, to measure the transmittance.

### (6) Absorption wavelength

The transmittance of a translucent substrate provided with a coating film to a light having a wavelength of from 240 to 2,400 nm was measured by a spectrophotometer (manufactured by Hitachi, Ltd., model: U-4100) to obtain the absorption wavelength.

### (7) Emission wavelength

The fluorescence properties of a translucent substrate provided with a coating film in the ineffective wavelength region (from 250 to 400 nm) was measured by a fluorophotometer (manufactured by Hamamatsu Photonics K.K., model: C9920-02) to obtain the emission wavelength.

### (8) Power generation efficiency of solar cell

A sample having a translucent substrate provided with a coating film bonded to the light receiving surface side of a solar cell by means of an ethylene/vinyl acetate copolymer resin was irradiated with artificial sunlight by using a solar simulator (manufactured by SAN-ELECTRIC CO., LTD., model: XES-301S) to measure the power generation efficiency. Based on a sample having a translucent substrate without a coating film bonded to a solar cell, the power generation efficiency improvement ratio when the translucent substrate provided with a coating film was used was calculated. In a case where figured glass was used, the translucent substrate was disposed so that the non-figured surface faced the light receiving surface.

### [Preparation of coating fluid for wavelength conversion film]

### <Coating fluid A>

Into a 200 mL glass container, 3.5 g of an aqueous dispersion of YVO₄:Eu particles (average primary particle size: 20 nm, solid content concentration: 20 mass%, Eu doping amount: 10 mol% based on YVO₄), 3 g of a silicate hydrolysate (manufactured by COLCOAT CO., LTD., product name: HAS-10, solid content concentration: 10 mass%) and 93.5 g of ethanol were put to prepare coating fluid A.

### <Coating fluid B>

Into a 200 mL glass container, 3.5 g of an aqueous dispersion of YVO₄:Eu, Bi particles (average primary particle size: 20 nm, solid content concentration: 20 mass%, Eu doping amount: 5 mol% based on YVO₄, Bi doping amount: 2 mol% based on YVO₄), 3 g of a silicate hydrolysate (manufactured by COLCOAT CO., LTD., product name: HAS-10, solid content concentration: 10 mass%) and 93.5 g of ethanol were put to prepare coating fluid B.

### <Coating fluid C>

Into a 200 mL glass container, 3.5 g of an aqueous dispersion of YVO₄:Eu, Bi particles (average primary particle size: 20 nm, solid content concentration: 20 mass%, Eu doping amount: 10 mol% based on YVO₄, Bi doping amount: 0.2 mol% based on YVO₄), 3 g of a silicate hydrolysate (manufactured by COLCOAT CO., LTD., product name: HAS-10, solid content concentration: 10 mass%) and 93.5 g of ethanol were put to prepare coating fluid C.

### <Coating fluid D>

Into a 200 mL glass container, 3 g of an aqueous dispersion of SiO₂-coated YVO₄:Eu, Bi particles (average primary particle size: 30 nm, solid content concentration: 30 mass%, Eu doping amount: 5 mol% based on YVO₄, Bi doping amount: 0.5 mol% based on YVO₄, SiO₂ thickness: 5 nm), 1 g of a silicate hydrolysate (manufactured by COLCOAT CO., LTD., product name: HAS-10, solid content concentration: 10 mass%) and 96 g of ethanol were put to prepare coating fluid D.

### <Coating fluid E>

Into a 200 mL glass container, 35 g of an aqueous dispersion of ZnS:Mn particles (average primary particle size: 4 nm, solid content concentration: 2 mass%, Mn doping amount: 8 mol% based on ZnS, dispersing agent: mercaptopropionic acid), 3 g of a silicate hydrolysate (manufactured by COLCOAT CO., LTD., product name: HAS-10, solid content concentration: 10 mass%) and 62 g of methanol were put to prepare coating fluid E.

### <Coating fluid F>

Into a 200 mL glass container, 22.5 g of an ethanol dispersion of SiO₂-coated ZnO particles (average primary particle size: 5 nm, solid content concentration: 4 mass%, Si0₂ thickness: 1 nm), 1 g of a silicate hydrolysate (manufactured by COLCOAT CO., LTD., product name: HAS-10, solid content concentration: 10 mass%) and 76.5 g of ethanol were put to prepare coating fluid F.

### <Coating fluid G>

Into a 200 mL glass container, 35 g of a toluene dispersion of ZnSe:Mn particles (average primary particle size: 3 nm, solid content concentration: 2 mass%, Mn doping amount: 5 mass%, dispersing agent: oleylamine), 1.5 g of a perhydropolysilazane solution (manufactured by AZ Electronic Materials (Japan) K.K., product name: Aquamica NP110, solid content concentration: 20 mass%) and 63.5 g of toluene were put to prepare coating fluid G.

### <Coating fluid H>

Into a 200 mL glass container, 22.5 g of a toluene dispersion of ZnS-coated ZnSe particles (average primary particle size: 3 nm, solid content concentration: 2 mass%, ZnS thickness: 1 nm), 0.5 g of a perhydropolysilazane solution (manufactured by AZ Electronic Materials (Japan) K.K., product name: Aquamica NP110, solid content concentration: 20 mass%) and 77 g of toluene were put to prepare coating fluid H. [Preparation of coating fluid for antireflection film and coating fluid for optical functional film (layer)]

### <Coating fluid I>

Into a 200 mL glass container, 3.5 g of an aqueous dispersion of hollow SiO₂ particles (average primary particle size: 30 nm, solid content concentration: 20 mass%, SiO₂ thickness: 5 nm, refractive index: 1.25), 3 g of a silicate hydrolysate (manufactured by COLCOAT CO., LTD., product name: HAS-10, solid content concentration: 10 mass) and 93.5 g of ethanol were put to prepare coating fluid I.

### <Coating fluid J>

Into a 200 mL glass container, 50 g of coating fluid A and 50 g of coating fluid I were put to prepare coating fluid J.

### <Coating fluid K>

Into a 200 mL glass container, 50 g of coating fluid C and 50 g of coating fluid I were put to prepare coating fluid K.

### <Coating fluid L>

Into a 200 mL glass cotainer, 3.5 g of an aqueous dispersion of hollow SiO₂ particles containing YVO₄:Eu (Eu doping amount: 10 mol% based on YVO₄) (average primary particle size: 30 nm, solid content concentration: 20 mass%, shell thickness: 5 nm, refractive index: 1.28), 3 g of a silicate hydrolysate (manufactured by COLCOAT CO., LTD., product name: HAS-10, solid content concentration: 10 mass%) and 93.5 g of ethanol were put to prepare coating fluid L.

### [Example 1]

A step of applying coating fluid A to a non-tin surface of a highly transparent float glass (soda lime glass) substrate (100 mm × 100 mm, 4 mm in thickness, average transmittance to a light having a wavelength of from 300 to 400 nm: 75.49%, average reflectance by the above (4): 4.15%, the film refractive index by the above (3): 1.52) washed with cerium oxide, followed by spin coating at 500 rpm for 60 seconds for uniformalization, and firing the coating film at 200°C for 10 minutes, was repeatedly carried out 10 times to form a substrate front side wavelength conversion film (hereinafter referred to as "first wavelength conversion film") having a thickness of 1,000 nm, which converts a light in the first wavelength region into a light in the effective wavelength region. Then, coating fluid I was applied on the first wavelength conversion film, followed by spin coating at 500 rpm for 60 seconds for uniformalization, and the coating film was fired at 650°C for 10 minutes to form an antireflection film having a thickness of 100 nm. On the tin surface side of the obtained translucent substrate provided with a coating film, an amorphous silicon solar cell (in Table 1, the amorphous silicon solar cell is represented as a-Si) was formed, whereupon the performance of the solar cell was evaluated. Physical properties of the films and the solar cell performance are shown in Table 1.

The above non-tin surface of the glass substrate means a surface of the float glass plate produced by the float process, which had not been in contact with the molten tin surface in a float bath in the glass plate forming step (that is, the upper side surface of a glass ribbon, which was not in contact with the molten tin in the float bath when the glass ribbon flowed in the float bath in the glass plate forming step).

### [Example 2]

A step of applying coating fluid D to the non-figured surface of a highly transparent figured glass (soda lime glass) substrate (100 mm × 100 mm, 3.5 mm in thickness, average transmittance to a light having a wavelength of from 300 to 400 nm: 76.44%, average reflectance by the above (4): 4.16%, film refractive index by the above (3): 1.52) washed with cerium oxide, followed by spin coating at 500 rpm for 60 seconds for uniformalization, and firing the coating film at 200°C for 10 minutes was repeatedly carried out four times to form a first wavelength conversion film having a thickness of 400 nm. Then, coating fluid I was applied on the first wavelength conversion film, followed by spin coating at 450 rpm for 60 seconds for uniformalization, and the coating film was fired at 650°C for 10 minutes to form an antireflection film having a thickness of 120 nm.

Further, coating fluid G was applied on the figured surface of the highly transparent figured glass substrate having the antireflection film and the first wavelength conversion film formed on the non-figured surface, followed by spin coating at 1,500 rpm for 60 seconds for uniformalization, and the coating film was fired at 200°C for 10 minutes to form a substrate rear side wavelength conversion film (hereinafter referred to as "second wavelength conversion film") having a thickness of 100 nm which converts a light in the second wavelength region into a light in the effective wavelength region. A polycrystalline silicon solar cell (in Table 1, the polycrystalline silicon solar cell is represented as c-Si) was bonded to the figured surface side of the obtained translucent substrate provided with a coating film, whereupon the performance of the solar cell was evaluated. Physical properties of the films and the solar cell performance are shown in Table 1.

Here, the highly transparent figured glass substrate used in each of Examples 2 to 9 and 11 is figured glass produced by a figured glass production process and having fine concaves and convexes (hemispheres with a concave diameter of 750 µm, a concave depth of 160 µm and a pitch of 1.4 mm) formed on one side of a glass plate. The figured surface of the glass substrate is a surface having the above concaves and convexes formed thereon, and the non-figured surface of the glass substrate is a surface having the above concaves and convexes not formed thereon.

### [Example 3]

A step of applying coating fluid E to the non-figured surface of the same highly transparent figured glass substrate (100 mm × 100 mm, 3.5 mm in thickness) as in Example 2 washed with cerium oxide, followed by spin coating at 500 rpm for 60 seconds for uniformalization, and firing the coating film at 200°C for 10 minutes was repeatedly carried out five times to form a first wavelength conversion film having a thickness of 500 nm. Then, coating fluid I was applied on the first wavelength conversion film, followed by spin coating at 450 rpm for 60 seconds for uniformalization, and the coating film was fired at 650°C for 10 minutes to form an antireflection film having a thickness of 120 nm. A polycrystalline silicon solar cell was bonded to the figured surface side of the obtained translucent substrate provided with a coating film, whereupon the performance of the solar cell was evaluated. Physical properties of the film and the solar cell performance are shown in Table 1.

### [Example 4]

Coating fluid having a silicate hydrolysate (manufactured by COLCOAT CO., LTD., product name: HAS-10, solid content concentration: 10 mass%) diluted 5 times with ethanol was applied to the non-figured surface of the same highly transparent figured glass substrate (100 mm × 100 mm, 3.5 mm in thickness) as in Example 2 washed with cerium oxide, followed by spin coating at 500 rpm for 60 seconds for uniformalization, and the coating film was fired at 200°C for 10 minutes to form an antireflection film having a thickness of 100 nm. Then, coating fluid K was applied on the antireflection film, followed by spin coating at 450 rpm for 60 seconds for uniformalization, and the coating film was fired at 650°C for 10 minutes to form an optical functional layer having a thickness of 120 nm. A polycrystalline silicon solar cell was bonded to the figured surface side of the obtained translucent substrate provided with a coating film, whereupon the performance of the solar cell was evaluated. Physical properties of the films and the solar cell performance are shown in Table 1.

### [Example 5]

Coating fluid L was applied to the non-figured surface of the same highly transparent figured glass substrate (100 mm × 100 mm, 3.5 mm in thickness) as in Example 2 washed with cerium oxide, followed by spin coating at 450 rpm for 60 seconds, and the coating film was fired at 650°C for 10 minutes to form an optical functional layer having a thickness of 120 nm. Then, coating fluid F was applied to the figured surface of the highly transparent figured glass substrate having the optical functional layer formed on the non-figured surface, followed by spin coating at 700 rpm for 60 seconds for uniformalization, and the coating film was air-dried to form a second wavelength conversion film having a thickness of 300 nm. A polycrystalline silicon solar cell was bonded to the figured surface side of the obtained translucent substrate provided with a coating film, whereupon the performance of the solar cell was evaluated. Physical properties of the films and the solar cell performance are shown in Table 1.

### [Example 6]

Coating fluid J was applied to the non-figured surface of the same highly transparent figured glass substrate (100 mm × 100 mm, 3.5 mm in thickness) as in Example 2 washed with cerium oxide, followed by spin coating at 450 rpm for 60 seconds, and the coating film was fired at 650°C for 10 minutes to form an optical functional layer having a thickness of 120 nm. Then, coating fluid G was applied to the figured surface of the highly transparent figured glass substrate having the optical functional layer formed on the non-figured surface, followed by spin coating at 600 rpm for 60 seconds for uniformalization, and the coating film was air-dried to form a second wavelength conversion film having a thickness of 400 nm. A polycrystalline silicon solar cell was bonded to the figured surface side of the obtained translucent substrate provided with a coating film, whereupon the performance of the solar cell was evaluated. Physical properties of the films and the solar cell performance are shown in Table 1.

### [Example 7]

A step of applying coating fluid E to the non-figured surface of the same highly transparent figured glass substrate (100 mm × 100 mm, 3.5 mm in thickness) as in Example 2 washed with cerium oxide, followed by spin coating at 500 rpm for 60 seconds for uniformalization, and firing the coating film at 200°C for 10 minutes, was repeatedly carried out five times to form a first wavelength conversion film having a thickness of 500 nm. Then, coating fluid K was applied on the first wavelength conversion film, followed by spin coating at 400 rpm for 60 seconds for uniformalization, and the coating film was fired at 650°C for 10 minutes to form an optical functional layer having a thickness of 140 nm, which is an antireflection film having a wavelength conversion function. Further, coating fluid H was applied to the figured surface of the highly transparent figured glass substrate having the first wavelength conversion film and the optical functional layer formed on the figured surface, followed by spin coating at 1,000 rpm for 60 seconds for uniformalization, and the coating film was fired at 200°C for 10 minutes to form a second wavelength conversion film having a thickness of 200 nm. A CIGS compound semiconductor solar cell was bonded to the figured surface side of the obtained translucent substrate provided with a coating film, whereupon the performance of the solar cell was evaluated. Physical properties of the films and the solar cell performance are shown in Table 1.

### [Example 8]

Coating fluid I was applied to the non-figured surface of the same highly transparent figured glass substrate (100 mm × 100 mm, 3.5 mm in thickness) as in Example 2 washed with cerium oxide, followed by spin coating at 420 rpm for 60 seconds, and the coating film was fired at 200°C for 10 minutes to form an antireflection film having a thickness of 120 nm. Then, coating fluid B was applied to the figured surface of the highly transparent figured glass substrate having the antireflection film formed on the non-figured surface, followed by spin coating at 200 rpm for 60 seconds for uniformalization, and the coating film was fired at 650°C for 10 minutes to form a second wavelength conversion film having a thickness of 1,000 nm. A polycrystalline silicon solar cell was bonded to the figured surface side of the obtained translucent substrate provided with a coating film, whereupon the performance of the solar cell was evaluated. Physical properties of the films and the solar cell performance are shown in Table 1.

### [Example 9]

A step of applying coating fluid A to the non-figured surface of the same highly transparent figured glass substrate (100 mm × 100 mm, 3.5 mm in thickness) as in Example 2 washed with cerium oxide, followed by spin coating at 500 rpm for 60 seconds for unformalization, and firing the coating film at 200°C for 10 minutes, was repeatedly carried out 10 times to form a first wavelength conversion film having a thickness of 1,000 nm. A polycrystalline silicon solar cell was bonded to the figured surface side of the obtained translucent substrate provided with a coating film, whereupon the performance of the solar cell was evaluated. Physical properties of the film and the solar cell performance are shown in Table 2.

### [Example 10]

A step of applying coating fluid H to the non-tin surface of the same highly transparent float glass substrate (100 mm × 100 mm, 4 mm in thickness) as in Example 1 washed with cerium oxide, followed by spin coating at 500 rpm for 60 seconds for uniformalization, and firing the coating film at 200°C for 10 minutes, was repeatedly carried out 5 times to form a second wavelength conversion film having a thickness of 500 nm. An amorphous silicon solar cell was formed on the non-tin surface side of the obtained translucent substrate provided with a coating film, whereupon the performance of the solar cell was evaluated. Physical properties of the film and the solar cell performance are shown in Table 2.

### [Example 11]

Coating fluid I was applied to the non-figured surface of the same highly transparent figured glass substrate (100 × 100 mm, 3.5 mm in thickness) as in Example 2 washed with cerium oxide, followed by spin coating at 450 rpm for 60 seconds for uniformalization, and the coating film was fired at 200°C for 10 minutes to form an antireflection film having a thickness of 120 nm. Then, a step of applying coating fluid A to the antireflection film, followed by spin coating at 500 rpm for 60 seconds for uniformalization, and firing the coating film at 200°C for 10 minutes, was repeatedly carried out 5 times to form a first wavelength conversion film having a thickness of 500 nm. A polycrystalline silicon solar cell was bonded to the figured surface side of the obtained translucent substrate provided with a coating film, whereupon the performance of the solar cell was evaluated. Physical properties of the film and the solar cell performance are shown in Table 2.

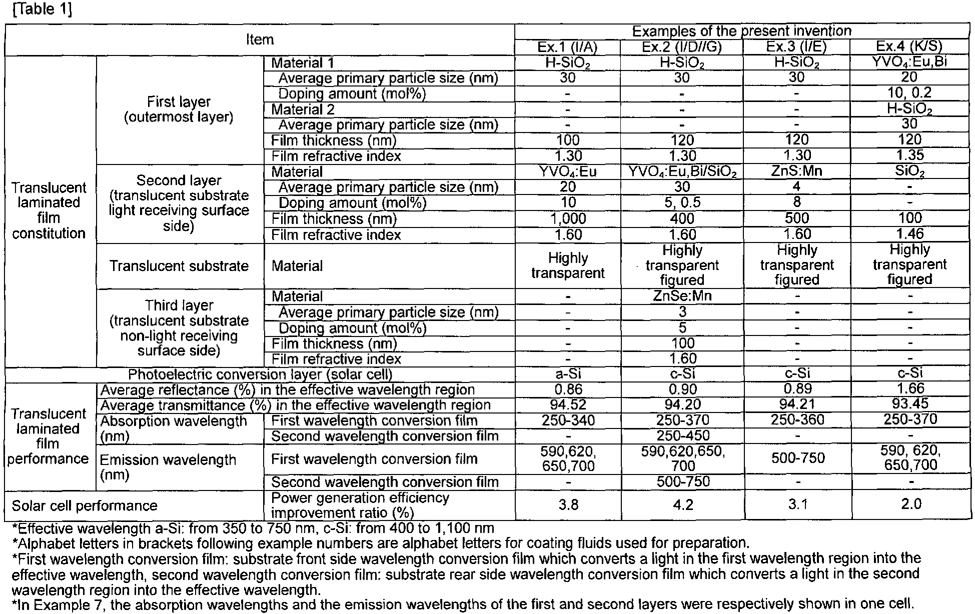

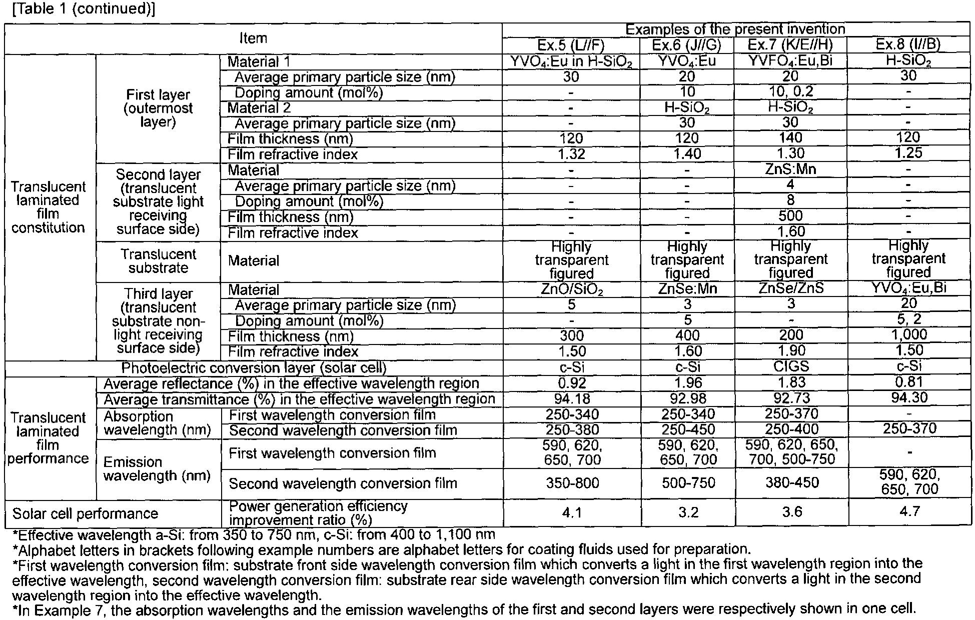

**[Table 2]**

| Item | | | Comparative Examples | | |
|---|---|---|---|---|---|
| | | | Ex.9(A) | Ex.10(/H) | Ex.11 (A/l) |
| Translucent laminated film constitution | First layer (outermost layer) | Material 1 | YVO₄:Eu | - | YVO₄:Eu |
| | | Average primary particle size (nm) | 20 | - | 20 |
| | | Doping amount (mol%) | 10 | - | 10 |
| | | Material 2 | - | - | - |
| | | Average particle size primary (nm) | - | - | - |
| | | Film thickness (nm) | 1, 000 | - | 500 |
| | | Film refractive index | 1.60 | - | 1. 60 |
| | Second layer (translucent substrate light receiving surface side) | Material | - | - | H-SiO₂ |
| | | Average particle s primary ze (nm) | - | - | 30 |
| | | Doping amount (mol%) | - | - | - |
| | | Film thickness (nm) | - | | 120 |
| | | Film refractive index | - | - | 1.30 |
| | Translucent substrate | Material | Highly transparent figured | Highly transparent | Highly transparent figured |
| | Third layer (translucent substrate non-light receiving surface side) | Material | - | ZnSe/ZnS | - |
| | | Average particle s primary ze (nm) | - | 3 | - |
| | | Doping amount (mol%) | - | - | - |
| | | Film thickness (nm) | - | 500 | - |
| | | Film refractive index | - | 1.90 | - |
| Photoelectric conversion layer (solar cell) | | | c-Si | a-Si | c-Si |
| Translucent laminated film performance | Average reflectance (%) in the effective wavelength region | | 5.38 | 4.89 | 6.91 |
| | Average transmittance (%) in the effective wavelength reqion | | 89.73 | 89.66 | 88.19 |
| | Absorption wavelength (nm) | First wavelength conversion film | 250-340 | - | 250-340 |
| | | Second wavelength conversion film | - | 250-400 | - |
| | Emission wavelength (nm) | First wavelength conversion film | 590,620,650, 700 | - | 590,620,650, 700 |
| | | Second wavelength conversion film | - | 380-450 | - |
| Solar cell performance | | Power generation efficiency improvement ratio (%) | -0.9 | -0.2 | -2.9 |

| | | | | | |
|---|---|---|---|---|---|
| *Effective wavelength a-Si: from 350 to 750 nm, c-Si: from 400 to 1,100 nm *Alphabet letters in brackets following example numbers are alphabet letters for coating fluids used for preparation. *First wavelength conversion film: substrate front side wavelength conversion film which converts a light in the first wavelength region into the effective wavelength, second wavelength conversion film: substrate rear side wavelength conversion film which converts a light in the second wavelength region into the effective wavelength. | | | | | |

In Examples 1 to 8 in which the constitution order of the substrate front side wavelength conversion film, the substrate rear side wavelength conversion film, the antireflection film, the optical functional film and the translucent substrate is within the range of the present invention, and in Examples 5 to 8 in which the refractive index design is within the range of the present invention, the power generation efficiency of a solar cell can effectively be improved by a synergistic effect of the antireflection function and the wavelength conversion function. Further, the highly transparent figured glass is a figured glass plate, and in a case where the wavelength conversion film was formed on the figured surface, the refractive index of the film can be suppressed to be low as compared with a flat surface, and a higher wavelength conversion efficiency is obtained. The refractive index design is within a preferred range.

Whereas in Examples 9 and 10 in which only the wavelength conversion film is formed, or in Example 11 in which the constitution order of the wavelength conversion film and the antireflection film is out of the range of the present invention, no sufficient effects of the antireflection function and the wavelength conversion function can be obtained, and the power generation efficiency of a solar cell is rather decreased. Accordingly, the constitution order of the wavelength conversion film, the antireflection film and the optical functional layer and the refractive index design of the present invention are important to effectively improve the power generation efficiency of a solar cell, and it is useful to design the absorption wavelength and the emission wavelength of the wavelength conversion film in conformity with the photoelectric conversion characteristics of a solar cell, in order to obtain higher effects.

### INDUSTRIAL APPLICABILITY

The present invention provides a laminated film to be used for a device having a photoelectric conversion layer such as a solar cell module, which makes a light in a wavelength region in which the photoelectric conversion efficiency is high efficiently reach the photoelectric conversion layer and which also has a protection function to increase the durability of the photoelectric conversion layer such as the weather resistance and the mechanical strength, which is useful, for example, as a cover glass for a solar cell.

The entire disclosure of Japanese Patent Application No. 2010-134296 filed on June 11, 2010 including specification, claims, drawings and summary is incorporated herein by reference in its entirety.

### REFERENCE SYMBOLS

1: Photoelectric conversion layer
11: Photoelectric conversion layer light receiving surface
100: Translucent laminated film
110: Translucent substrate
120: Substrate front side wavelength conversion film
130: Antireflection film
140, 141: Substrate rear side wavelength conversion film
150: Optical functional film

## Claims

1. A translucent laminated film to be provided on the light receiving surface side of a photoelectric conversion layer, which comprises, in order from the light receiving surface side of the photoelectric conversion layer,
a translucent substrate which protects the photoelectric conversion layer,
a substrate front side wavelength conversion film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, and
an antireflection film which reduces reflection of the received light.

2. The translucent laminated film according to Claim 1, which further has a substrate rear side wavelength conversion film having a wavelength conversion function to convert a light in a wavelength region in which the photoelectric conversion efficiency by the photoelectric conversion layer is low, which has passed through the translucent substrate, into a light in a wavelength region in which the photoelectric conversion efficiency is high, on the photoelectric conversion layer side of the translucent substrate.

3. The translucent laminated film according to Claim 2, wherein the wavelength at the long wavelength end of a light which is wavelength-converted by the substrate front side wavelength conversion film, is shorter than the wavelength at the long wavelength end of a light which is wavelength-converted by the substrate rear side wavelength conversion film.

4. The translucent laminated film according to any one of Claims 1 to 3, wherein the average refractive index of the substrate front side wavelength conversion film and/or the substrate rear side wavelength conversion film to a light having a wavelength of from 300 to 1,000 nm in the film thickness direction, is within a range of from 1.2 to 2.0.

5. A translucent laminated film to be provided on the light receiving surface side of a photoelectric conversion layer, which comprises, in order from the light receiving surface side of the photoelectric conversion layer,
a substrate rear side wavelength conversion film having a wavelength conversion function to convert a light in a wavelength region in which the photoelectric conversion efficiency by the photoelectric conversion layer is low, which has passed through the following translucent substrate, into a light in a wavelength region in which the photoelectric conversion efficiency is high, and having an average refractive index to a light having a wavelength of from 300 to 1,000 nm in the film thickness direction of from 1.2 to 2.0,
a translucent substrate which protects the photoelectric conversion layer, and
an antireflection film which prevents reflection of the received light.

6. The translucent laminated film according to Claim 5, wherein the substrate rear side wavelength conversion film contains a matrix material having an average refractive index to a light having a wavelength of from 300 to 1,000 nm in the film thickness direction of from 1.2 to 1.7, and a wavelength conversion material having the above wavelength conversion function.

7. The translucent laminated film according to Claim 6, wherein the content of the matrix material is from 1 to 50 mass% based on the total solid content of components constituting the substrate rear side wavelength conversion film.

8. The translucent laminated film according to any one of Claims 1 to 7, wherein the antireflection film has a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high.

9. The translucent laminated film according to any one of Claims 1 to 8, wherein the average refractive index of the substrate front side wavelength conversion film and/or the antireflection film to a light having a wavelength of from 300 to 1,000 nm in the film thickness direction, is within a range of from 1.1 to 1.5.

10. The translucent laminated film according to any one of Claims 1 to 9, wherein the antireflection film is a porous film.

11. The translucent laminated film according to any one of Claims 1 to 10, wherein the substrate front side wavelength conversion film and/or the substrate rear side wavelength conversion film is a single layer film containing a plurality of wavelength conversion materials each having a wavelength conversion function corresponding to each wavelength conversion film, and containing a material which converts a light having a short wavelength at the light absorption long wavelength end by the light receiving surface side of each film.

12. The translucent laminated film according to any one of Claims 1 to 10, wherein the substrate front side wavelength conversion film and/or the substrate rear side wavelength conversion film is a multilayer film comprising a plurality of wavelength conversion layers and having a layer having a short wavelength at the light absorption long wavelength end by the light receiving surface side of each film.

13. The translucent laminated film according to any one of Claims 1 to 12, wherein the substrate front side wavelength conversion film and/or the substrate rear side wavelength conversion film contains inorganic fine particles having an average primary particle size of from 0.5 to 300 nm as a wavelength conversion material.

14. A translucent laminated film to be provided on the light receiving surface side of a photoelectric conversion layer, which comprises, in order from the light receiving surface side of the photoelectric conversion layer,
a translucent substrate which protects the photoelectric conversion layer, and
an optical functional film having a wavelength conversion function to convert a light in a wavelength region in which the photoelectric conversion efficiency by the photoelectric conversion layer is low, which includes a light in a wavelength region in which the transmittance through at least the translucent substrate is low, into a light in a wavelength region in which the photoelectric conversion efficiency is high, and having an antireflection function to reduce reflection of the received light.

15. The translucent laminated film according to Claim 14, wherein the optical functional film contains a wavelength conversion material having the above wavelength conversion function, and contains hollow particles having an average refractive index to a light having a wavelength of from 300 to 1,000 nm within a range of from 1.1 to 1.8.

16. The translucent laminated film according to Claim 14 or 15, which further has a substrate rear side wavelength conversion film having a wavelength conversion function to convert a light in a wavelength region in which the photoelectric conversion efficiency by the photoelectric conversion layer is low, which has passed through the translucent substrate, into a light in a wavelength region in which the photoelectric conversion efficiency is high, on the photoelectric conversion layer side of the translucent substrate.

17. The translucent laminated film according to Claim 16, wherein the wavelength at the long wavelength end of a light which is wavelength-converted by the optical functional film, is shorter than the wavelength at the long wavelength end of a light which is wavelength-converted by the substrate rear side wavelength conversion film.

18. The translucent laminated film according to any one of Claims 14 to 17, wherein the average refractive index of the optical functional film to a light having a wavelength of from 300 to 1,000 nm in the film thickness direction, is within a range of from 1.1 to 1.5.

19. The translucent laminated film according to any one of Claims 14 to 18, wherein the optical functional film is a porous film.

20. The translucent laminated film according to any one of Claims 14 to 19, wherein the optical functional film and/or the substrate rear side wavelength conversion film is a single layer film containing a plurality of wavelength conversion materials each having a wavelength conversion function corresponding to each film, and containing a material which converts a light having a short wavelength at the light absorption long wavelength end by the light receiving surface side of each film.

21. The translucent laminated film according to any one of Claims 14 to 19, wherein the optical functional film and/or the substrate rear side wavelength conversion film is a multilayer film comprising a plurality of wavelength conversion layers and having a layer having a short wavelength at the light absorption long wavelength end by the light receiving surface side of each film.

22. The translucent laminated film according to any one of Claims 14 to 21, wherein the optical functional film and/or the substrate rear side wavelength conversion film contains inorganic fine particles having an average primary particle size of from 0.5 to 300 nm as a wavelength conversion material.

23. The translucent laminated film according to any one of Claims 1 to 22, wherein the average transmittance to a light of from 300 to 400 nm from the light receiving surface side to the non-light receiving surface side of the translucent substrate is at least 75%.

24. The translucent laminated film according to any one of Claims 1 to 23, wherein the average reflectance at the light receiving surface to a light in a wavelength region in which the photoelectric conversion efficiency by the photoelectric conversion layer is high, is at most 2%.

25. The translucent laminated film according to any one of Claims 1 to 24, wherein the average transmittance from the light receiving surface side to the non-light receiving surface side to a light in a wavelength region in which the photoelectric conversion efficiency by the photoelectric conversion layer is high, is at least 90%.

26. A protective cover on the light receiving surface side of a solar cell, which comprises the translucent laminated film as defined in any one of Claims 1 to 25.

27. A solar cell module, which comprises the translucent laminated film as defined in any one of Claims 1 to 25 as a protective cover on the light receiving surface side of a solar cell.
